# EUROPEAN PATENT APPLICATION

(11) **EP 4 657 873 A1**
(43) Date of publication of application: **03.12.2025**
(21) Application number: 24747224.4
(22) Date of filing: 19.01.2024
(51) Int. Cl.: H04N 25/773, H01L 27/146

(54) **PHOTOELECTRIC CONVERSION DEVICE, PHOTODETECTION SYSTEM, AND MOBILE OBJECT**

(30) Priority: 23.01.2023 JP 2023008010; 04.01.2024 JP 2024000212
(71) Applicant: Canon Kabushiki Kaisha, Tokyo, 146-8501 (JP)
(72) Inventor: MAEHASHI Yu, Tokyo 146-8501 (JP); OTA Yasuharu, Tokyo 146-8501 (JP)
(74) Representative: TBK
(86) International application number: PCT/JP2024/001474
(87) International publication number: WO 2024/157896

(57) **Abstract**

A photoelectric conversion device is configured by stacking a first substrate, a second substrate, and a third substrate and includes a plurality of pixels each including a photoelectric conversion unit including an APD and a signal processing unit that processes a signal output from the photoelectric conversion unit. The signal processing unit includes a quenching circuit connected to the APD and a processing circuit that processes a signal corresponding to incidence of light on the APD. The APD is arranged on the first substrate, at least a part of the quenching circuit is arranged on the second substrate, and at least a part of the processing circuit is arranged on the third substrate. Each of the plurality of pixels includes a plurality of electrical connection portions between the second substrate and the third substrate, a part of the plurality of electrical connection portions constitutes a part of an input signal line to the processing circuit, and another part constitutes a part of an output signal line from the processing circuit.

## Description

### [Technical Field]

The present invention relates to a photoelectric conversion device, a photodetection system, and a movable object.

### [Background Art]

A photoelectric conversion device including a pixel array in which a plurality of pixels each including an avalanche photodiode (APD) is arranged in a two-dimensional array is known. PTL 1 discloses a photoelectric conversion device configured by stacking a first substrate on which an APD array is disposed, and a second substrate and a third substrate on which circuits for controlling the operation of the APD array and processing signals output from the APD array are disposed.

### [Citation List]

### [Patent Literature]

PTL 1: Japanese Patent Laid-Open No. 2022-113123

### [Summary of Invention]

### [Technical Problem]

However, in the configuration described in PTL 1, each functional block constituting the circuit for controlling the operation of the APD array and processing the signals output from the APD array is not necessarily appropriately distributed to the second substrate and the third substrate, which may hinder improvement in characteristics and high integration.

An object of the present invention is to provide a technique for facilitating high integration and improvement of characteristics of functional blocks of pixel circuits and peripheral circuits in a photoelectric conversion device configured by stacking three or more substrates.

### [Solution to Problem]

According to one disclosure of the present specification, there is provided a photoelectric conversion device, configured by stacking at least a first substrate, a second substrate, and a third substrate, including a plurality of pixels each including a photoelectric conversion unit including an avalanche photodiode, and a signal processing unit configured to process a signal output from the photoelectric conversion unit, wherein the signal processing unit of each of the plurality of pixels includes a quenching circuit connected to the avalanche photodiode and a processing circuit configured to process a signal according to incidence of light on the avalanche photodiode, wherein the avalanche photodiode is arranged on the first substrate, wherein at least a part of the quenching circuit is arranged on the second substrate, wherein at least a part of the processing circuit is arranged on the third substrate, wherein each of the plurality of pixels includes a plurality of electrical connection portions between the second substrate and the third substrate, and wherein a part of the plurality of electrical connection portions constitutes a part of an input signal line to the processing circuit, and another part of the plurality of electrical connection portions constitutes a part of an output signal line from the processing circuit.

According to another disclosure of the present specification, there is provided a photoelectric conversion device, configured by stacking at least a first substrate, a second substrate, and a third substrate, including a plurality of pixels arranged to form a plurality of rows and a plurality of columns and each including a photoelectric conversion unit including an avalanche photodiode, and a signal processing unit configured to process a signal output from the photoelectric conversion unit, and a plurality of output lines provided corresponding to the plurality of rows or the plurality of columns and each connected to pixels of a corresponding row or a corresponding column, wherein the signal processing unit of each of the plurality of pixels includes: an input node connected to the avalanche photodiode; a processing circuit configured to process a signal according to incidence of light on the avalanche photodiode; and an output node connected to the output line, wherein the avalanche photodiode is arranged on the first substrate, wherein the input node and the output node of the signal processing unit, and the output line are arranged on the second substrate, and wherein at least a part of the processing circuit is arranged on the third substrate.

### [Advantageous Effects of Invention]

According to the present invention, in a photoelectric conversion device configured by stacking three or more substrates, it is possible to realize high integration and improved characteristics of pixel circuits and functional blocks of peripheral circuits.

### [Brief Description of Drawings]

[FIG. 1]

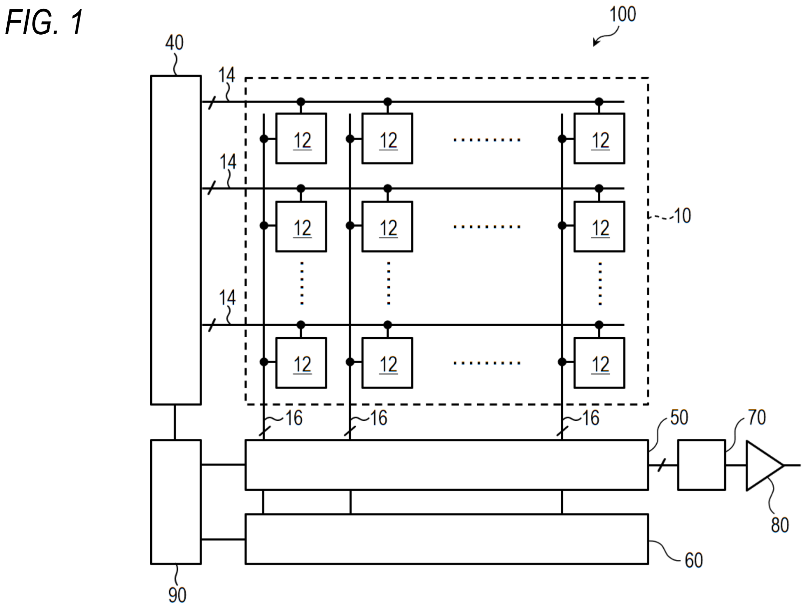

   FIG. 1 is a block diagram illustrating a schematic configuration of a photoelectric conversion device according to a first embodiment of the present invention (Part 1).
[FIG. 2]

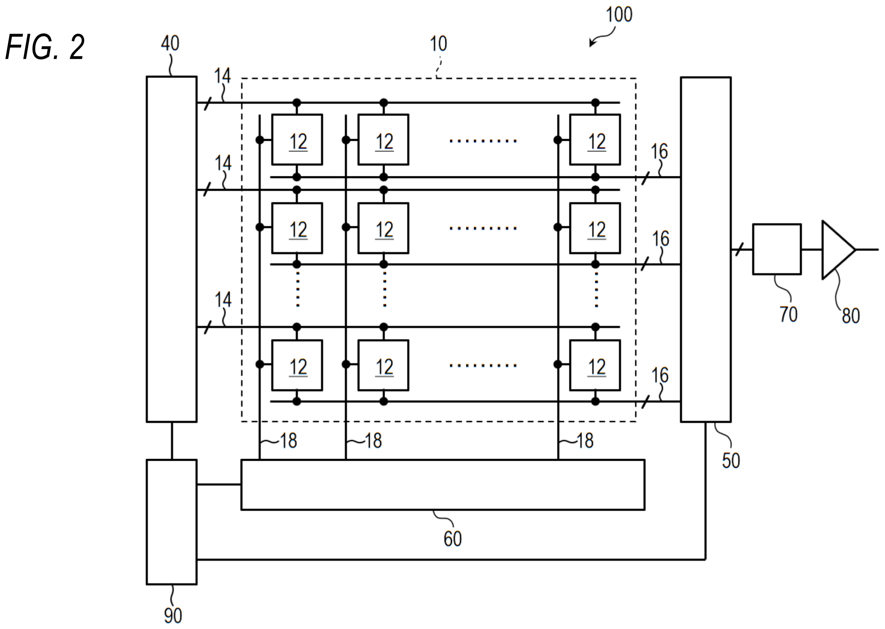

   FIG. 2 is a block diagram illustrating a schematic configuration of the photoelectric conversion device according to the first embodiment of the present invention (Part 2).
[FIG. 3]

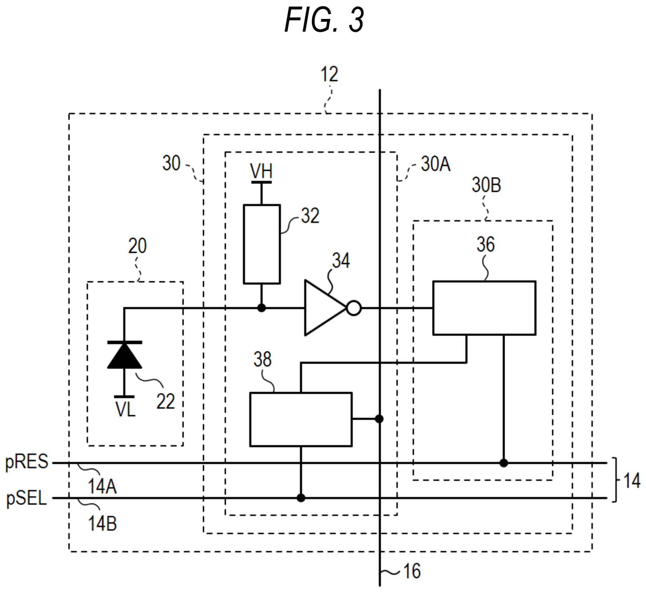

   FIG. 3 is a block diagram illustrating a configuration example of a pixel of the photoelectric conversion device according to the first embodiment of the present invention.
[FIG. 4]

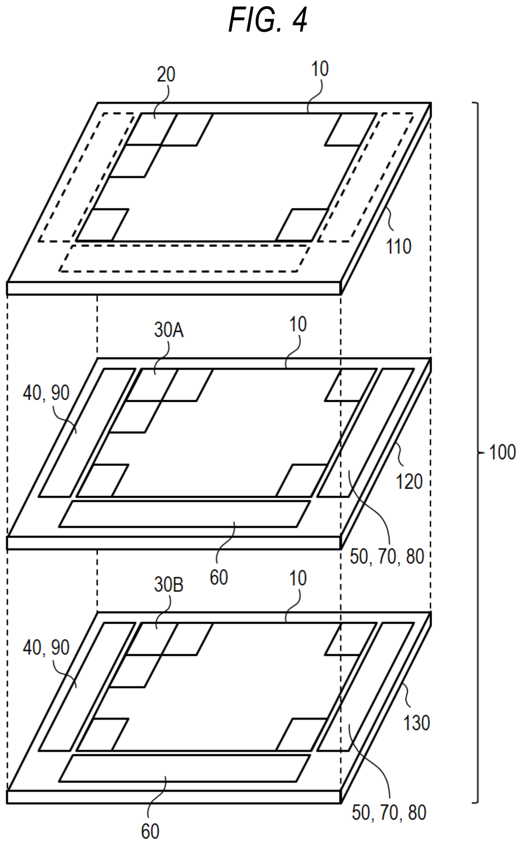

   FIG. 4 is a perspective view illustrating a configuration example of the photoelectric conversion device according to the first embodiment of the present invention.
[FIG. 5A]

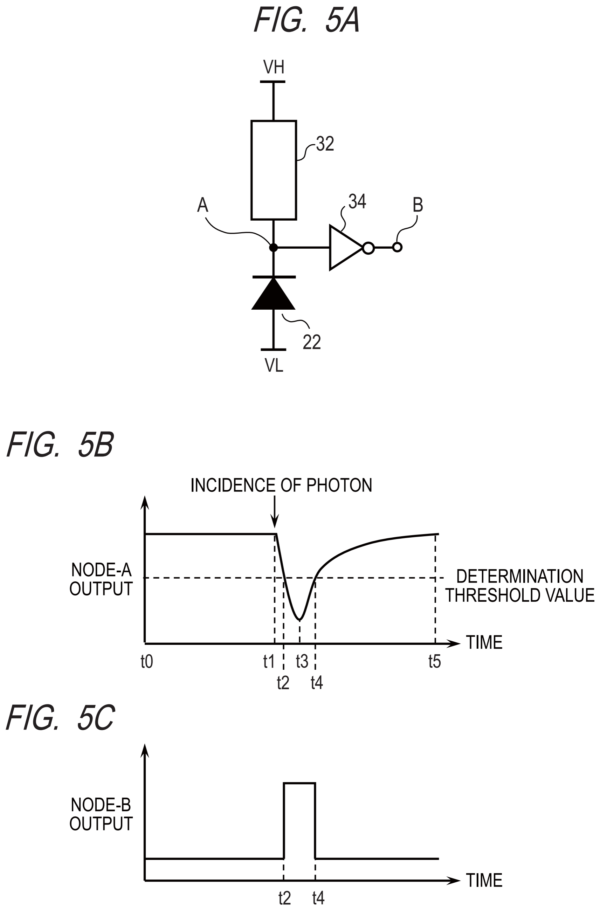

   FIG. 5A is a diagram illustrating a basic operation of the photoelectric conversion unit in the photoelectric conversion device according to the first embodiment of the present invention (Part 1).
[FIG. 5B]
   FIG. 5B is a diagram illustrating the basic operation of the photoelectric conversion unit in the photoelectric conversion device according to the first embodiment of the present invention (Part 2).
[FIG. 5C]
   FIG. 5C is a diagram illustrating the basic operation of the photoelectric conversion unit in the photoelectric conversion device according to the first embodiment of the present invention (Part 3).
[FIG. 6]

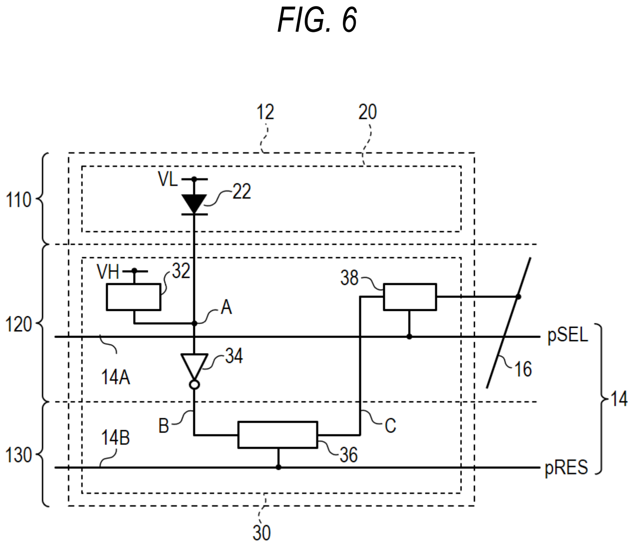

   FIG. 6 is a diagram schematically illustrating a stacked structure of the pixel in the photoelectric conversion device according to the first embodiment of the present invention.
[FIG. 7]

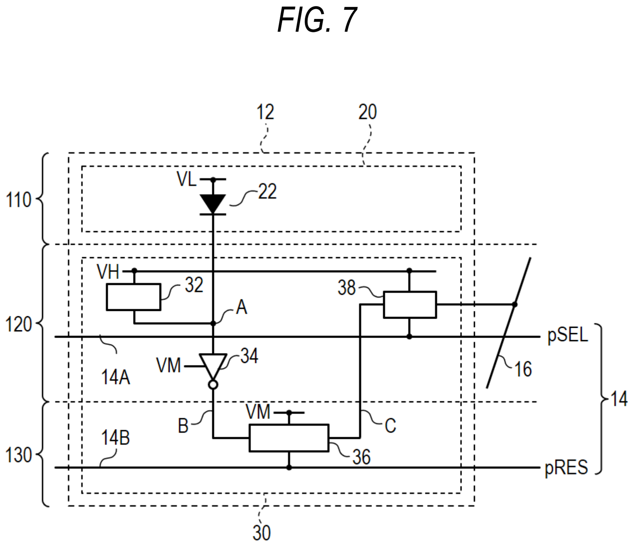

   FIG. 7 is a diagram schematically illustrating a stacked structure of a pixel in a photoelectric conversion device according to a modification of the first embodiment of the present invention.
[FIG. 8]

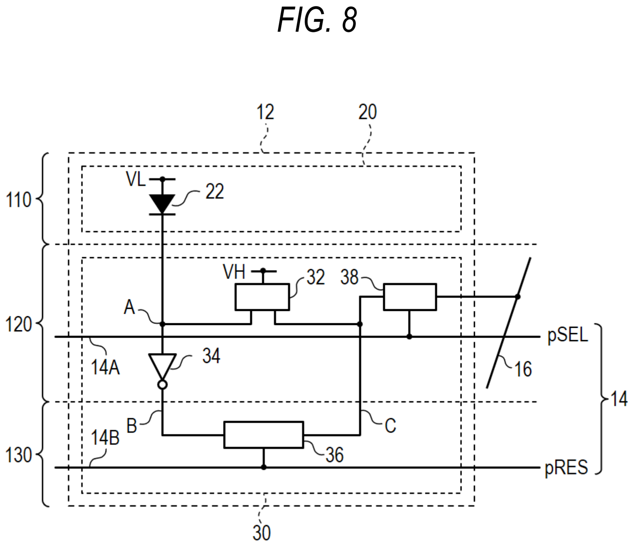

   FIG. 8 is a diagram schematically illustrating a stacked structure of a pixel in a photoelectric conversion device according to a modification of a second embodiment of the present invention.
[FIG. 9]

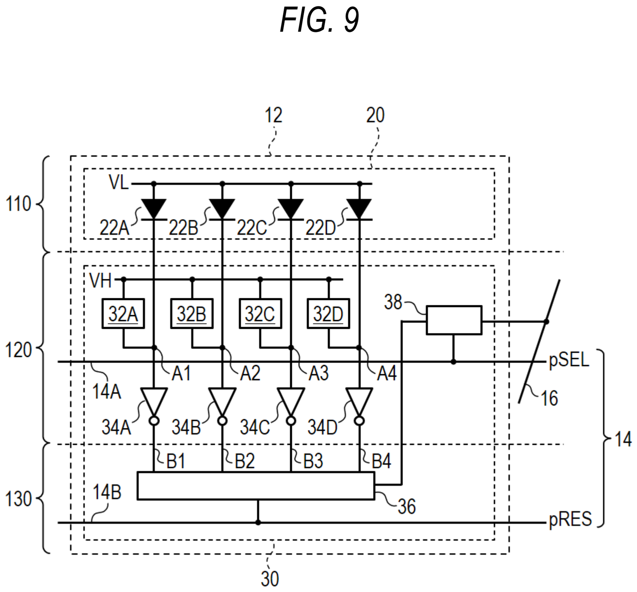

   FIG. 9 is a diagram schematically illustrating a stacked structure of a pixel in a photoelectric conversion device according to a third embodiment of the present invention.
[FIG. 10]

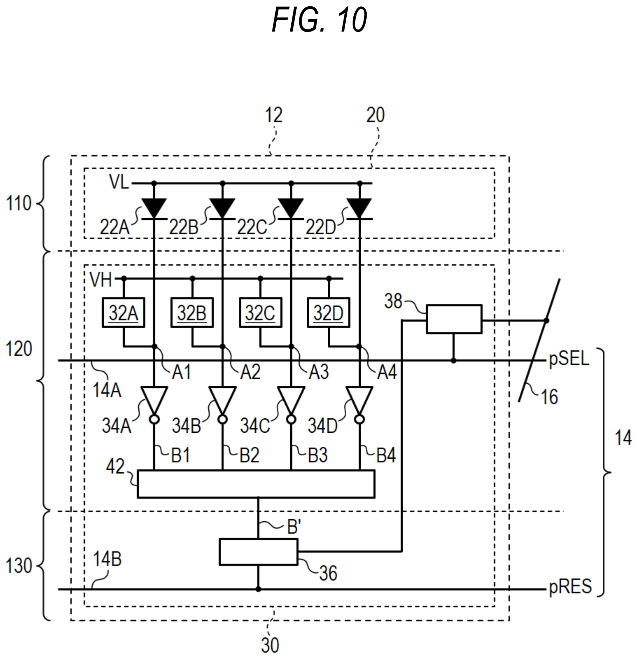

   FIG. 10 is a diagram schematically illustrating a stacked structure of a pixel in a photoelectric conversion device according to a modification of the third embodiment of the present invention.
[FIG. 11]

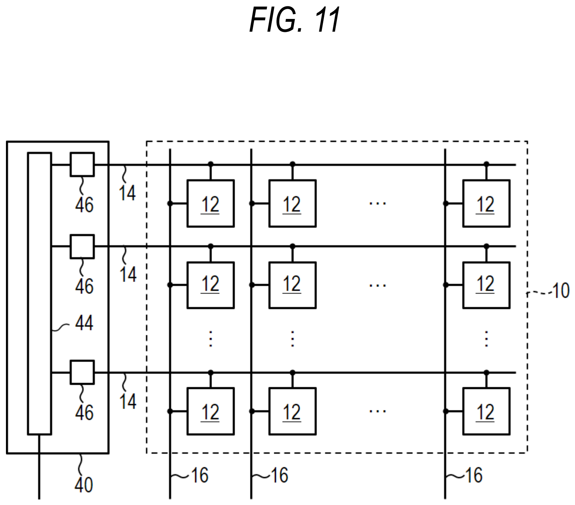

   FIG. 11 is a diagram illustrating a connection relationship between a vertical scanning circuit unit and a pixel region in a photoelectric conversion device according to a fourth embodiment of the present invention.
[FIG. 12]

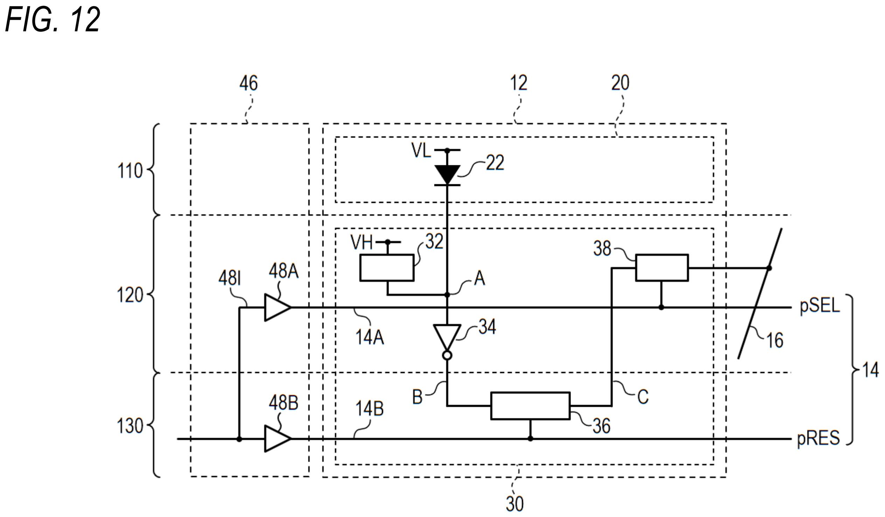

   FIG. 12 is a diagram schematically illustrating a stacked structure of a vertical scanning circuit unit in the photoelectric conversion device according to the fourth embodiment of the present invention.
[FIG. 13]

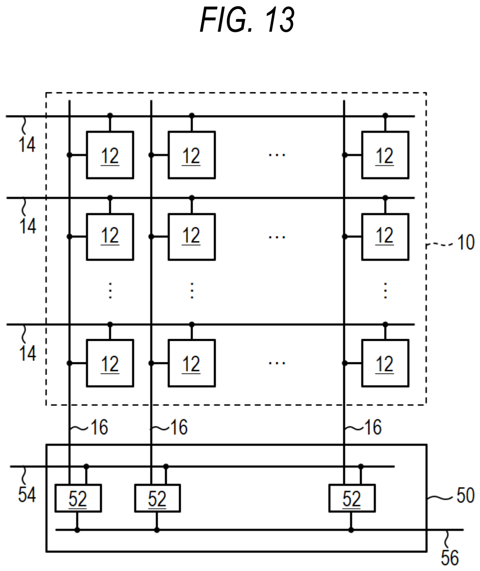

   FIG. 13 is a diagram illustrating a connection relationship between a readout circuit unit and a pixel region in a photoelectric conversion device according to a fifth embodiment of the present invention.
[FIG. 14]

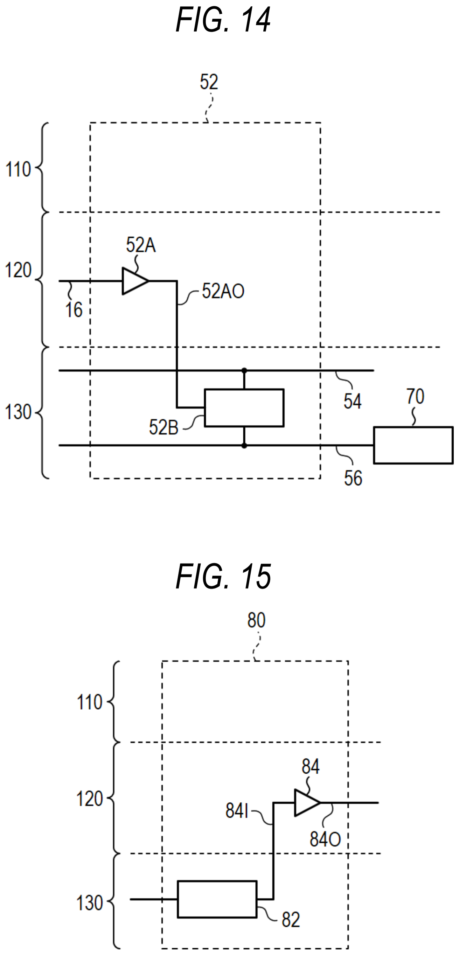

   FIG. 14 is a diagram schematically illustrating a stacked structure of the readout circuit unit in the photoelectric conversion device according to the fifth embodiment of the present invention.
[FIG. 15]
   FIG. 15 is a diagram schematically illustrating a stacked structure of a transmitter in a photoelectric conversion device according to a modification of a sixth embodiment of the present invention.
[FIG. 16]

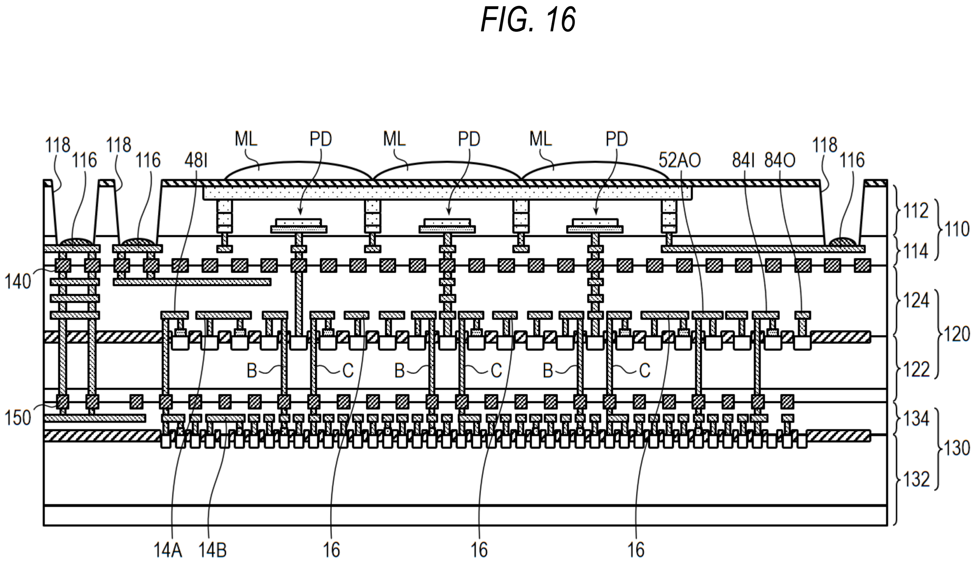

   FIG. 16 is a diagram schematically illustrating a stacked structure of a photoelectric conversion device according to a seventh embodiment of the present invention.
[FIG. 17]

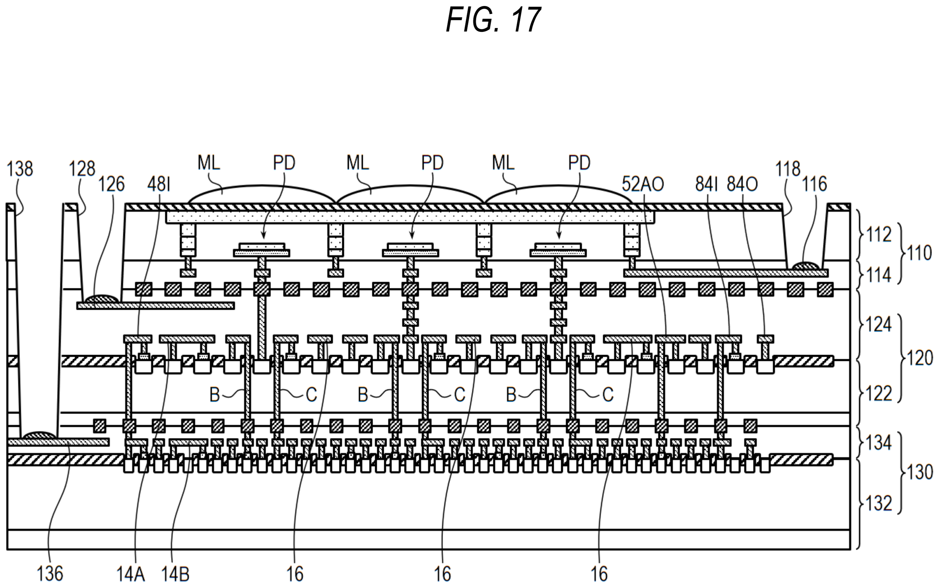

   FIG. 17 is a diagram schematically illustrating the stacked structure of the photoelectric conversion device according to the seventh embodiment of the present invention.
[FIG. 18]

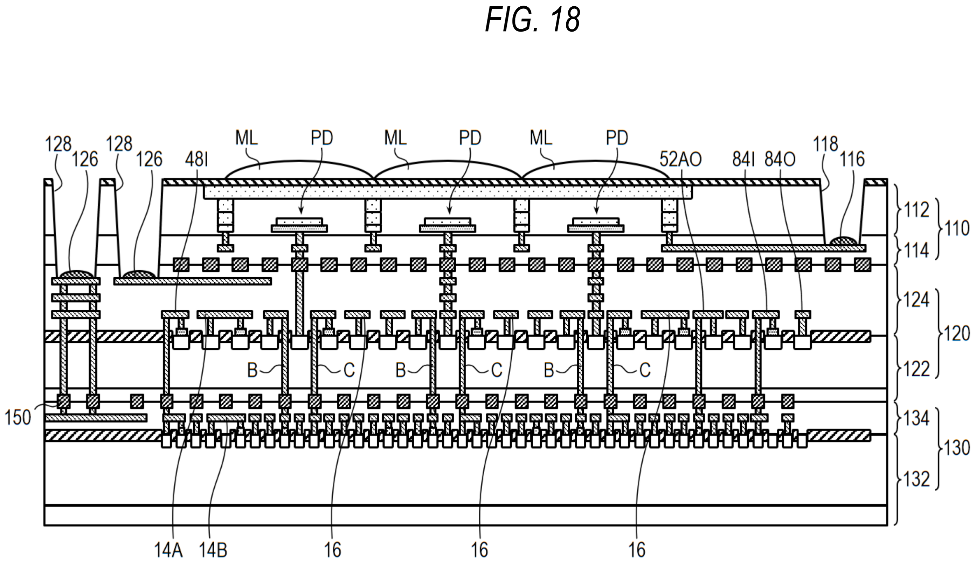

   FIG. 18 is a diagram schematically illustrating the stacked structure of the photoelectric conversion device according to the seventh embodiment of the present invention.
[FIG. 19]

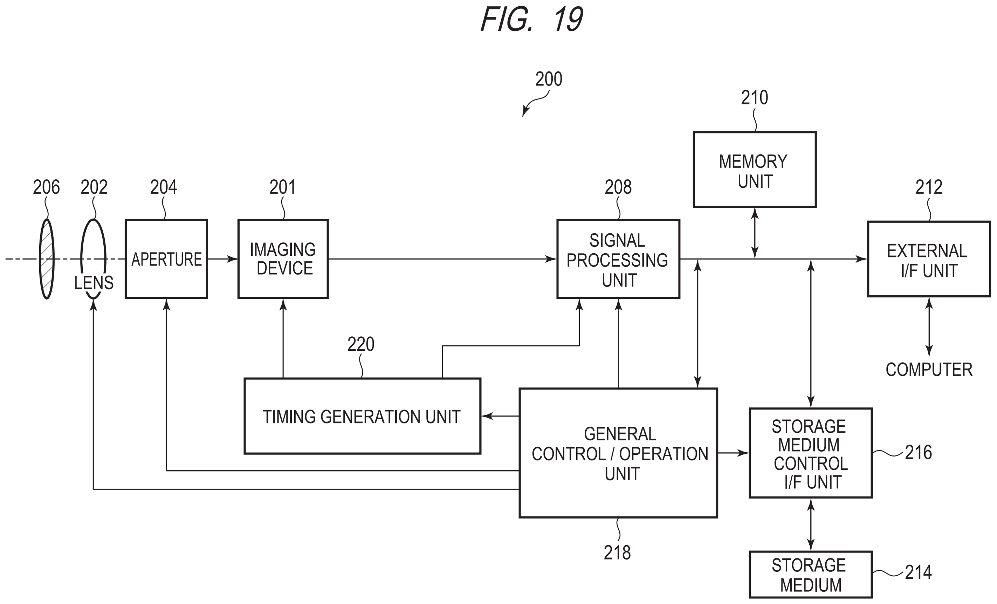

   FIG. 19 is a block diagram illustrating a schematic configuration of a photodetection system according to an eighth embodiment of the present invention.
[FIG. 20]

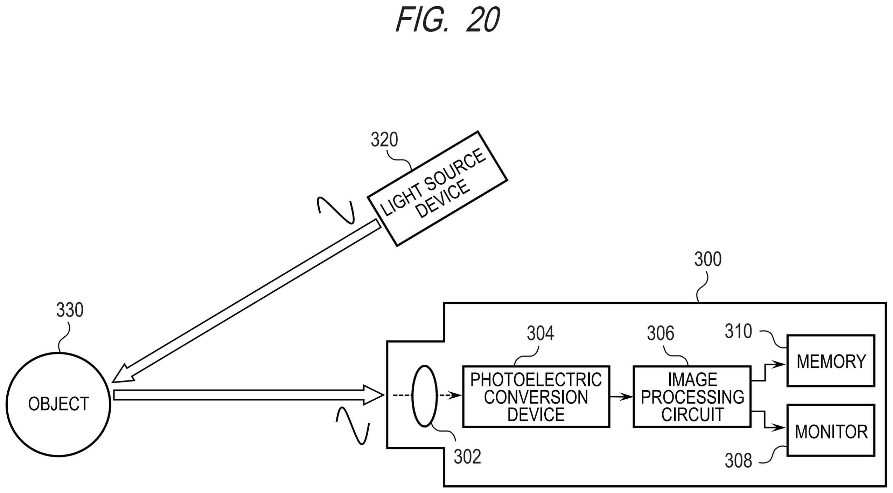

   FIG. 20 is a block diagram illustrating a schematic configuration of a range image sensor according to a ninth embodiment of the present invention.
[FIG. 21]

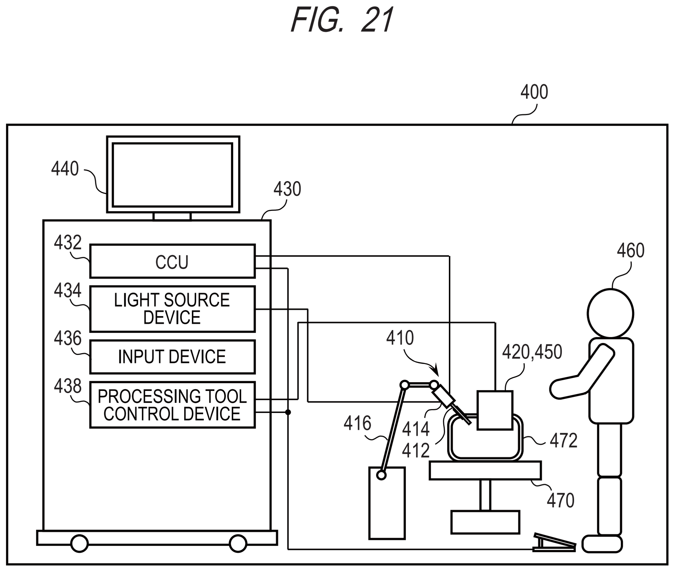

   FIG. 21 is a schematic diagram illustrating a configuration example of an endoscopic surgical system according to a tenth embodiment of the present invention.
[FIG. 22A]

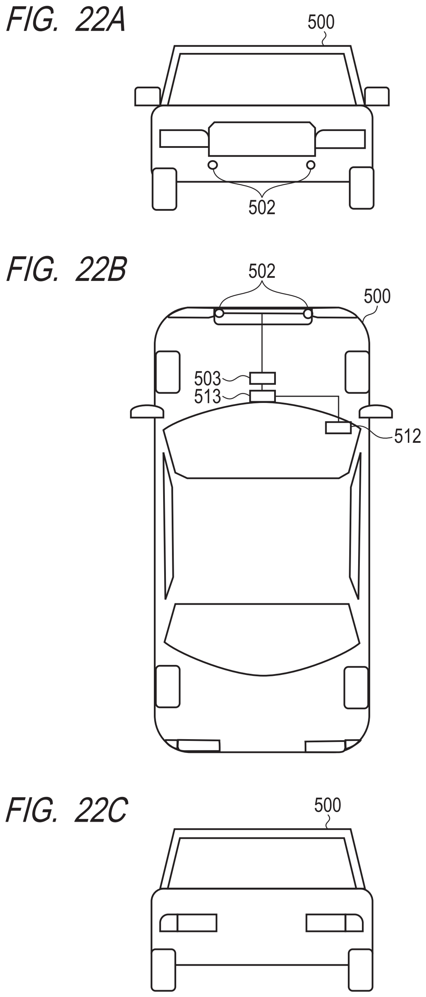

   FIG. 22A is a schematic diagram illustrating a configuration example of a movable object according to an eleventh embodiment of the present invention (Part 1).
[FIG. 22B]
   FIG. 22B is a schematic diagram illustrating the configuration example of the movable object according to the eleventh embodiment of the present invention (Part 2).
[FIG. 22C]
   FIG. 22C is a schematic diagram illustrating the configuration example of the movable object according to the eleventh embodiment of the present invention (Part 3).
[FIG. 23]

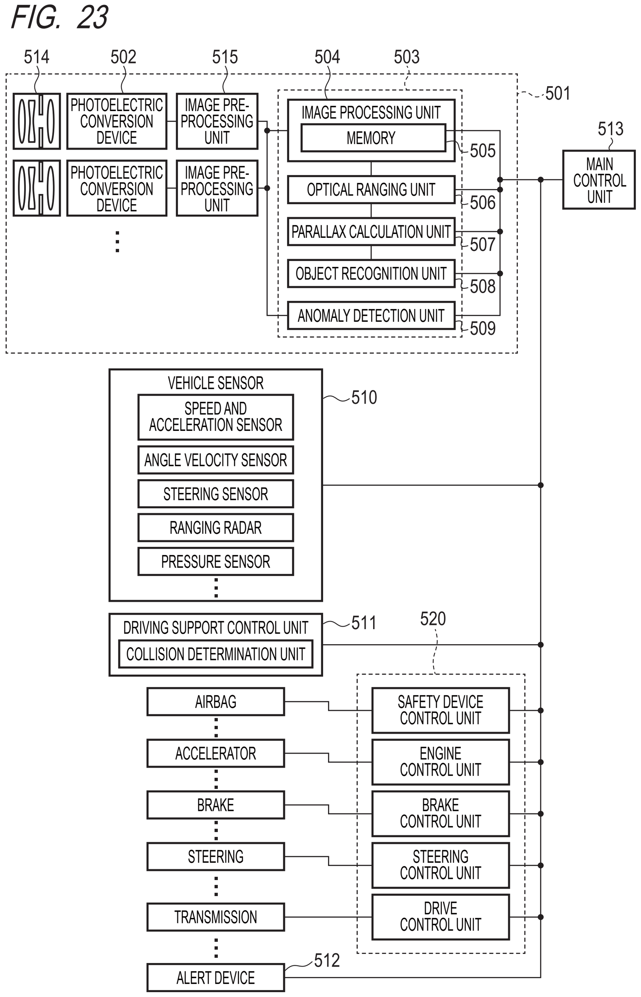

   FIG. 23 is a block diagram illustrating a schematic configuration of a photodetection system according to the eleventh embodiment of the present invention.
[FIG. 24]

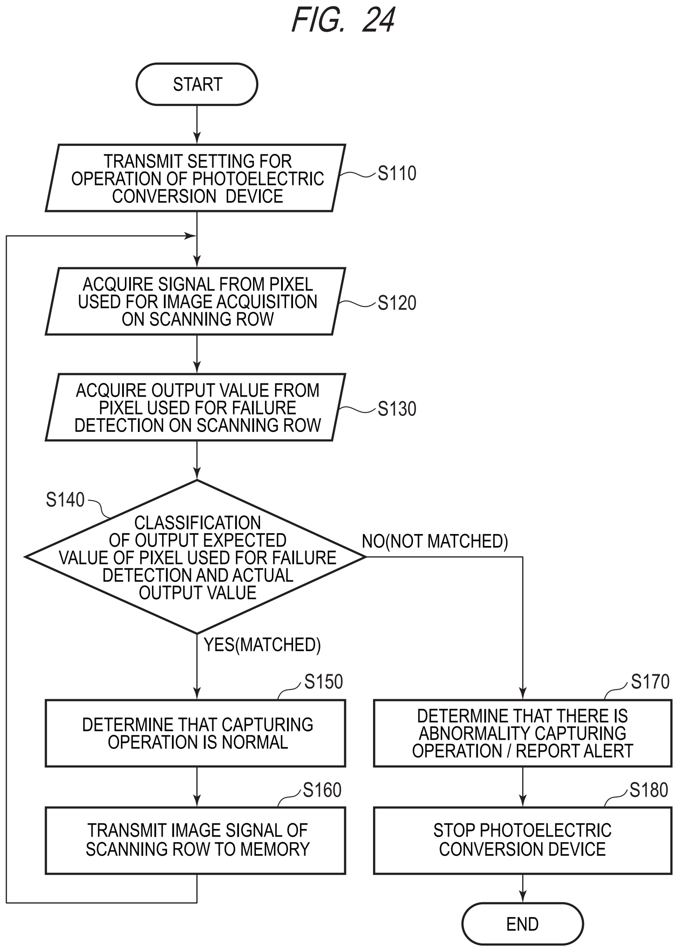

   FIG. 24 is a flowchart illustrating an operation of the photodetection system according to the eleventh embodiment of the present invention.
[FIG. 25A]

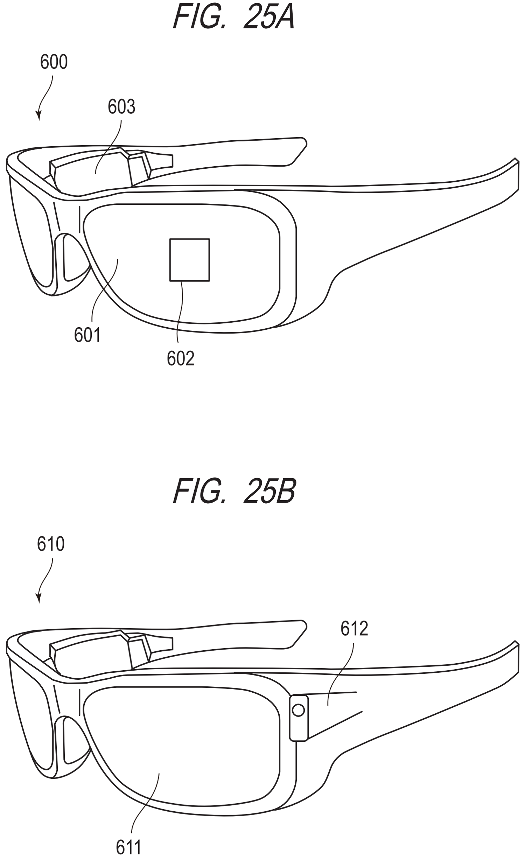

   FIG. 25A is a schematic diagram illustrating a schematic configuration of a photodetection system according to a twelfth embodiment of the present invention (Part 1).
[FIG. 25B]
   FIG. 25B is a schematic diagram illustrating a schematic configuration of a photodetection system according to the twelfth embodiment of the present invention (Part 2).

### [Description of Embodiments]

The following embodiments are intended to embody the technical idea of the present invention, and do not limit the present invention. The sizes and positional relationships of members illustrated in the drawings may be exaggerated for clarity of description. In the following description, the same components are denoted by the same reference numerals, and the description thereof may be omitted.

### [First Embodiment]

A schematic configuration of a photoelectric conversion device according to a first embodiment of the present invention will be described with reference to FIG. 1 to FIG. 4. FIG. 1 and FIG. 2 are block diagrams illustrating a schematic configuration of the photoelectric conversion device according to the present embodiment. FIG. 3 is a block diagram illustrating a configuration example of a pixel of the photoelectric conversion device according to the present embodiment. FIG. 4 is a perspective view illustrating a configuration example of the photoelectric conversion device according to the present embodiment.

As illustrated in FIG. 1, the photoelectric conversion device 100 according to the present embodiment includes a pixel region 10, a vertical scanning circuit unit 40, a readout circuit unit 50, a horizontal scanning circuit unit 60, a digital front end (DFE) 70, a transmitter circuit unit (TX) 80, and a control pulse generation unit 90.

The pixel region 10 is provided with a plurality of pixels 12 arranged in an array so as to form a plurality of rows and a plurality of columns. As described later, each pixel 12 may include a photoelectric conversion unit including a photoelectric conversion element and a signal processing unit that processes a signal output from the photoelectric conversion unit. The number of pixels 12 constituting the pixel region 10 is not particularly limited. For example, like a general digital camera, the pixel region 10 may be constituted by a plurality of pixels 12 arranged in an array of several thousand rows × several thousand columns. Alternatively, the pixel region 10 may include a plurality of pixels 12 arranged in one row or one column. Alternatively, one pixel 12 may constitute the pixel region 10.

In each row of the pixel array of the pixel region 10, a control line 14 is arranged so as to extend in a first direction (lateral direction in FIG. 1). Each of the control lines 14 is connected to the pixels 12 arranged in the first direction, respectively, and forms a signal line common to these pixels 12. The first direction in which the control lines 14 extend may be referred to as a row direction or a horizontal direction. Each of the control lines 14 may include a plurality of signal lines for supplying a plurality of types of control signals to the pixels 12. The control line 14 of each row is connected to the vertical scanning circuit unit 40.

Further, in each column of the pixel array of the pixel region 10, an output line 16 is arranged so as to extend in a second direction (vertical direction in FIG. 1) intersecting the first direction. Each of the output lines 16 is connected to the pixels 12 arranged in the second direction, respectively, and forms a signal line common to these pixels 12. The second direction in which the output lines 16 extend may be referred to as a column direction or a vertical direction. Each of the output lines 16 may include a plurality of signal lines for transferring a digital signal of a plurality of bits output from the pixel 12 on a bit-by-bit basis.

The control line 14 of each row is connected to the vertical scanning circuit unit 40. The vertical scanning circuit unit 40 is a control circuit having a function of generating a control signal for driving the pixels 12 in response to a control signal output from the control pulse generation unit 90, and supplying the generated control signal to the pixels 12 via the control line 14. A logic circuit such as a shift register or an address decoder may be used as the vertical scanning circuit unit 40. The vertical scanning circuit unit 40 sequentially scans the pixels 12 in the pixel region 10 row by row to output pixel signals of the pixels 12 to the readout circuit unit 50 via the output lines 16.

The output line 16 of each column is connected to the readout circuit unit 50. The readout circuit unit 50 includes a plurality of holding units (not illustrated) provided corresponding to each column of the pixel array of the pixel region 10 and has a function of holding the pixel signals of the pixels 12 of each column output from the pixel region 10 in units of rows via the output lines 16 in the holding units of the corresponding columns.

The horizontal scanning circuit unit 60 is a control circuit that generates a control signal for reading out a pixel signal from the holding unit of each column of the readout circuit unit 50 in response to a control signal output from the control pulse generation unit 90 and supplies the generated control signal to the readout circuit unit 50. A logic circuit such as a shift register or an address decoder may be used as the horizontal scanning circuit unit 60. The horizontal scanning circuit unit 60 sequentially scans the holding units of each column of the readout circuit unit 50 and sequentially outputs the pixel signals held in the holding units to the digital front end 70.

The DFE 70 is a signal processing circuit unit that performs predetermined digital signal processing on the pixel signal output from the readout circuit unit 50. The DFE 70 sequentially outputs the pixel signals subjected to the digital signal processing to the TX 80.

The TX 80 is a circuit unit that includes an external interface circuit and outputs the pixel signal output from the readout circuit unit 50 to the outside of the photoelectric conversion device 100. The external interface circuit included in the TX 80 is not particularly limited. As the external interface circuit, for example, a SerDes (SERializer/DESerializer) transmission circuit such as a LVDS (Low Voltage Differential Signaling) circuit or a SLVS (Scalable Low Voltage Signaling) circuit may be applied.

The control pulse generation unit 90 is a control circuit for generating control signals for controlling the operations and timings thereof of the vertical scanning circuit unit 40, the readout circuit unit 50, and the horizontal scanning circuit unit 60, and supplying the generated control signals to each functional block. At least a part of the control signals for controlling the operations and timings thereof of the vertical scanning circuit unit 40, the readout circuit unit 50, and the horizontal scanning circuit unit 60 may be supplied from the outside of the photoelectric conversion device 100.

The connection mode of each functional block of the photoelectric conversion device 100 is not limited to the configuration example of FIG. 1 and may be configured as illustrated in FIG. 2, for example.

In the configuration example of FIG. 2, the output line 16 extending in the first direction is arranged in each row of the pixel array of the pixel region 10. Each of the output lines 16 is connected to the pixels 12 arranged in the first direction, respectively, and forms a signal line common to these pixels 12. A control line 18 extending in the second direction is arranged in each column of the pixel array of the pixel region 10. Each of the control lines 18 is connected to the pixels 12 arranged in the second direction, respectively, and forms a signal line common to these pixels 12.

The control line 18 of each column is connected to the horizontal scanning circuit unit 60. The horizontal scanning circuit unit 60 generates a control signal for reading out a pixel signal from the pixel 12 in response to a control signal output from the control pulse generation unit 90 and supplies the generated control signal to the pixel 12 via the control line 18. Specifically, the horizontal scanning circuit unit 60 sequentially scans the plurality of pixels 12 in the pixel region 10 in units of columns, and outputs the pixel signals of the pixels 12 in each row belonging to the selected column to the output lines 16.

The output line 16 of each row is connected to the readout circuit unit 50. The readout circuit unit 50 includes a plurality of holding units (not illustrated) provided corresponding to the respective rows of the pixel array of the pixel region 10 and has a function of holding the pixel signals of the pixels 12 of the respective rows output from the pixel region 10 in units of columns via the output lines 16 in the holding units of the corresponding rows.

The readout circuit unit 50 sequentially outputs the pixel signals held in the holding units of the respective rows to the DFE 70 in response to the control signal output from the control pulse generation unit 90.

Other configurations in the configuration example of FIG. 2 may be the same as those in the configuration example of FIG. 1.

As illustrated in FIG. 3, each pixel 12 includes a photoelectric conversion unit 20 and a signal processing unit 30. The photoelectric conversion unit 20 includes a photoelectric conversion element 22 and outputs a signal according to incident light. The signal processing unit 30 is a signal processing circuit that processes the signal output from the photoelectric conversion unit 20. The signal processing unit 30 includes a functional block 30A including a quenching circuit 32, a waveform shaping circuit 34, and a selection circuit 38, and a functional block 30B including a processing circuit 36. In the case of the pixel configuration illustrated in FIG. 3, the control line 14 of each row may include a signal line 14A to which the control signal pRES is supplied from the vertical scanning circuit unit 40 and a signal line 14B to which the control signal pSEL is supplied from the vertical scanning circuit unit 40.

The photoelectric conversion element 22 may be an avalanche photodiode (hereinafter referred to as "APD"). An anode of the APD constituting the photoelectric conversion element 22 is connected to a node to which a voltage VL is supplied. A cathode of the APD constituting the photoelectric conversion element 22 is connected to one terminal of the quenching circuit 32. A connection node between the photoelectric conversion element 22 and the quenching circuit 32 is an output node of the photoelectric conversion unit 20. The other terminal of the quenching circuit 32 is connected to a node to which a voltage VH higher than the voltage VL is supplied. The voltage VL and the voltage VH are set so that a reverse bias voltage sufficient for the APD to perform the avalanche multiplication operation is applied. In one example, a negative high voltage is applied as the voltage VL, and a positive voltage comparable to the power supply voltage is applied as the voltage VH. For example, the voltage VL is -30 V, and the voltage VH is 1 V.

The photoelectric conversion element 22 may be configured by an APD as described above. When a reverse bias voltage sufficient to perform the avalanche multiplication operation is supplied to the APD, charge carriers generated by light incident on the APD cause avalanche multiplication, and an avalanche current is generated. The operation modes in a state where the reverse bias voltage is supplied to the APD include a Geiger mode and a linear mode. The Geiger mode is an operation mode in which a voltage applied between the anode and the cathode is set to a reverse bias voltage larger than the breakdown voltage of the APD. The linear mode is an operation mode in which a voltage applied between the anode and the cathode is set to a reverse bias voltage close to or lower than the breakdown voltage of the APD. An APD that operates in Geiger mode is referred to as SPAD (Single Photon Avalanche Diode). The APD constituting the photoelectric conversion element 22 may operate in a linear mode or a Geiger mode.

The quenching circuit 32 has a function of converting a change in the avalanche current generated in the photoelectric conversion element 22 into a voltage signal. In addition, the quenching circuit 32 functions as a load circuit (quenching circuit) at the time of signal multiplication by avalanche multiplication and has a function of suppressing avalanche multiplication by reducing a voltage applied to the photoelectric conversion element 22. The operation in which the quenching circuit 32 suppresses avalanche multiplication is called a quenching operation. In addition, the quenching circuit 32 has a function of returning the voltage supplied to the photoelectric conversion element 22 to the voltage VH by flowing a current corresponding to the voltage drop due to the quenching operation. The operation of returning the voltage supplied from the quenching circuit 32 to the photoelectric conversion element 22 to the voltage VH is called a recharge operation. The quenching circuit 32 may be configured by a resistor, a MOS transistor, and the like.

The waveform shaping circuit 34 includes an input node to which the output signal of the photoelectric conversion unit 20 is supplied and an output node. The waveform shaping circuit 34 has a function of converting an analog signal supplied from the photoelectric conversion unit 20 into a pulse signal. The waveform shaping circuit 34 may be configured by a logic circuit including a NOT circuit (inverter circuit), a NOR circuit, a NAND circuit, and the like. An output node of the waveform shaping circuit 34 is connected to the processing circuit 36.

The processing circuit 36 has an input node to which the output signal of the waveform shaping circuit 34 is supplied, an input node connected to the control line 14, and an output node. The processing circuit 36 has a function of performing predetermined signal processing on the output signal of the waveform shaping circuit 34 and holding the processed signal or the processing result. Although not particularly limited, the processing circuit 36 may be, for example, a counter circuit. In this case, the processing circuit 36 counts pulses superimposed on the signal output from the waveform shaping circuit 34 and holds a count value which is a count result. The signals supplied from the vertical scanning circuit unit 40 to the processing circuit 36 via the control line 14 may include an enable signal for controlling a pulse counting period (exposure period), a reset signal for resetting a count value held by the processing circuit 36, and the like. FIG. 3 illustrates, as an example, a reset signal (control signal pRES) supplied via the signal line 14A. The output node of the processing circuit 36 is connected to the selection circuit 38.

The selection circuit 38 has a function of switching an electrical connection state (connection or non-connection) between the processing circuit 36 and the output line 16. The selection circuit 38 switches the connection state between the processing circuit 36 and the output line 16 according to a selection signal supplied from the vertical scanning circuit unit 40 via the control line 14 (or a selection signal supplied from the horizontal scanning circuit unit 60 via the control line 18 in the configuration example of FIG. 2). FIG. 3 illustrates, as an example, a selection signal (control signal pSEL) supplied via the signal line 14B. The processing circuit 36 may include a buffer circuit for outputting the signals.

The pixel 12 is typically a unit structure that outputs a pixel signal for forming an image. However, in the case of aiming at distance measurement using a TOF (Time of Flight) method, the pixel 12 does not necessarily need to be a unit structure that outputs a pixel signal for forming an image. That is, the pixel 12 may be a unit structure that outputs a signal for measuring the time at which light arrives and the amount of light.

One signal processing unit 30 is not necessarily provided for each pixel 12, and one signal processing unit 30 may be provided for a plurality of pixels 12. In this case, the signal processing of the plurality of pixels 12 may be sequentially performed using one signal processing unit 30.

The photoelectric conversion device 100 according to the present embodiment is configured as a stacked-type photoelectric conversion device in which a plurality of substrates are stacked. That is, as illustrated in FIG. 4, the photoelectric conversion device 100 is configured by stacking three substrates of a sensor substrate 110, a circuit substrate 120, and a circuit substrate 130 and electrically connecting the substrates to each other.

At least the photoelectric conversion unit 20 among the constituent elements of the pixels 12 may be arranged on the sensor substrate 110. A functional block 30A of the signal processing unit 30 among the constituent elements of the pixels 12 may be arranged on the circuit substrate 120. A functional block 30B of the signal processing unit 30 among the constituent elements of the pixels 12 may be arranged on the circuit substrate 130. The pixel region 10 is provided in each of the sensor substrate 110, the circuit substrate 120, and the circuit substrate 130 so as to overlap each other in a plan view. The photoelectric conversion unit 20, the functional block 30A, and the functional block 30B of each of the plurality of pixels 12 configuring the pixel region 10 are provided on the sensor substrate 110, the circuit substrate 120, and the circuit substrate 130, respectively, so as to overlap each other in the plan view. The photoelectric conversion unit 20 and the functional block 30A, and the functional block 30A and the functional block 30B are electrically connected to each other via connection wirings (not illustrated) provided for each pixel 12. Here, the term "plan view" refers to a view from a direction perpendicular to the surface of the sensor substrate 110.

The circuit substrates 120 and 130 may further include a vertical scanning circuit unit 40, a readout circuit unit 50, a horizontal scanning circuit unit 60, a DFE 70, a TX 80, and a control pulse generation unit 90. The vertical scanning circuit unit 40, the readout circuit unit 50, the horizontal scanning circuit unit 60, the DFE 70, the TX 80, and the control pulse generation unit 90 may be disposed around the pixel region 10 in the circuit substrates 120 and 130. Each of the vertical scanning circuit unit 40, the readout circuit unit 50, the horizontal scanning circuit unit 60, the DFE 70, the TX 80, and the control pulse generation unit 90 may be provided on one of the circuit substrates 120 and 130 or may be provided by being divided into the circuit substrates 120 and 130.

By configuring the stacked-type photoelectric conversion device 100, it is possible to increase the degree of integration of elements and achieve higher functionality. In particular, by arranging the photoelectric conversion unit 20 and the signal processing unit 30 on different substrates, the photoelectric conversion elements 22 may be arranged at high density without sacrificing the light receiving area of the photoelectric conversion elements 22, and the photon detection efficiency may be improved. In addition, by arranging the functional block 30A and the functional block 30B of the signal processing unit 30 on different substrates, it is possible to achieve high integration and high functionality of the processing circuit 36 constituting the functional block 30B while arranging the photoelectric conversion elements 22 at high density.

In FIG. 4, diced chips are assumed as the sensor substrate 110 and the circuit substrates 120 and 130, but the sensor substrate 110 and the circuit substrates 120 and 130 are not limited to chips. For example, each of the sensor substrate 110 and the circuit substrates 120 and 130 may be a wafer. In addition, the sensor substrate 110 and the circuit substrates 120 and 130 may be stacked in a wafer state and then diced or may be stacked and bonded after being formed into chips.

Next, a basic operation of the photoelectric conversion unit 20 in the photoelectric conversion device according to the present embodiment will be described with reference to FIG. 5A to FIG. 5C. FIG. 5A to FIG. 5C are diagrams illustrating basic operations of the photoelectric conversion element 22, the quenching circuit 32, and the waveform shaping circuit 34 in the photoelectric conversion device according to the present embodiment. FIG. 5A is a circuit diagram of the photoelectric conversion element 22, the quenching circuit 32, and the waveform shaping circuit 34. FIG. 5B illustrates the waveform of the signal at the input node (node-A) of the waveform shaping circuit 34. FIG. 5C illustrates the waveform of the signal at the output node (node-B) of the waveform shaping circuit 34. Here, in order to simplify the description, it is assumed that the waveform shaping circuit 34 is configured by an inverter circuit.

At time t0, a reverse bias voltage having a potential difference corresponding to (VH-VL) is applied to the photoelectric conversion element 22. Although a reverse bias voltage sufficient to cause avalanche multiplication is applied between the anode and the cathode of the APD constituting the photoelectric conversion element 22, carriers serving as seeds of avalanche multiplication do not exist in a state where photons are not incident on the photoelectric conversion element 22. Therefore, avalanche multiplication does not occur in the photoelectric conversion element 22, and no current flows through the photoelectric conversion element 22.

At the subsequent time t1, it is assumed that a photon is incident on the photoelectric conversion element 22. When a photon enters the photoelectric conversion element 22, an electron-hole pair is generated by photoelectric conversion, avalanche multiplication occurs using these carriers as seeds, and an avalanche multiplication current flows through the photoelectric conversion element 22. When this avalanche multiplication current flows through the quenching circuit 32, a voltage drop occurs by the quenching circuit 32, and the voltage of the node-A starts to drop. When the voltage drop amount of the node-A becomes large and the avalanche multiplication is stopped at time t3, the voltage level of the node-A no longer drops.

When the avalanche multiplication in the photoelectric conversion element 22 is stopped, a current that compensates for the voltage drop flows from the node to which the voltage VL is supplied to the node-A through the photoelectric conversion element 22, and the voltage of the node-A gradually increases. Thereafter, at time t5, the node-A is settled to the original voltage level.

The waveform shaping circuit 34 binarizes the signal input from the node-A according to a predetermined determination threshold value, and outputs the signal from the node-B. Specifically, the waveform shaping circuit 34 outputs a low-level signal from the node-B when the voltage level of the node-A exceeds the determination threshold value, and outputs a high-level signal from the node-B when the voltage level of the node-A is equal to or less than the determination threshold value. For example, as illustrated in FIG. 5B, it is assumed that the voltage of the node-A is equal to or lower than the determination threshold value in the period from time t2 to time t4. In this case, as illustrated in FIG. 5C, the signal level at the node-B becomes low-level in the period from the time t0 to the time t2 and the period from the time t4 to the time t5 and becomes high-level in the period from the time t2 to the time t4.

Thus, the analog signal input from the node-A is waveform-shaped into a digital signal by the waveform shaping circuit 34. A pulse signal output from the waveform shaping circuit 34 in response to incidence of a photon on the photoelectric conversion element 22 is a photon detection pulse signal.

FIG. 6 is a diagram schematically illustrating the stacked structure of FIG. 4 in the pixel 12. A node-A, which is an electrical connection portion between the photoelectric conversion unit 20 and the signal processing unit 30, serves as a communication path between the sensor substrate 110 and the circuit substrate 120. A node-B, which is an electrical connection portion between the waveform shaping circuit 34 and the processing circuit 36, and a node-C, which is an electrical connection portion between the processing circuit 36 and the selection circuit 38, constitute a communication path between the circuit substrate 120 and the circuit substrate 130. That is, the analog signal output from the photoelectric conversion element 22 of the sensor substrate 110 is input to the waveform shaping circuit 34 of the circuit substrate 120 via the node-A. The pulse signal output from the waveform shaping circuit 34 reaches the processing circuit 36 of the circuit substrate 130 via the node-B, is subjected to the predetermined processing by the processing circuit 36, and then is input to the selection circuit 38 of the circuit substrate 120 via the node-C. From the viewpoint of ease of wiring with the selection circuit 38, the output line 16 is preferably arranged on the same circuit substrate 120 as the selection circuit 38.

As described above, each of the node-B and the node-C constitutes a part of the plurality of electrical connection portions between the circuit substrate 120 and the circuit substrate 130 included in each pixel 12. The node-B constitutes a part of an input signal line to the processing circuit 36, and the node-C constitutes a part of an output signal line from the processing circuit 36.

By adopting such a configuration, only the processing circuit 36 may be arranged in the pixel region 10 of the circuit substrate 130, and the area of the processing circuit 36 may be further increased. That is, according to the present embodiment, the selection circuit 38 does not affect the area of the processing circuit 36, and it is possible to realize high integration and high functionality of the processing circuit 36. In addition, by arranging the selection circuit 38 and the processing circuit 36 on different substrates, the element size of the selection circuit 38 may be increased. As a result, the driving capability of the selection circuit 38 may be increased, and the waveform quality of the signal transferred to the subsequent circuit may be improved. In particular, since a large parasitic capacitance is coupled to the output line 16 to which the plurality of pixels 12 are connected, the effect of increasing the driving capability of the selection circuit 38 is great.

The power supply voltage supplied to the elements provided on the circuit substrate 120 may be the same as or different from the power supply voltage supplied to the elements provided on the circuit substrate 130. In other words, the withstand voltage of the elements mounted on the circuit substrate 120 may be the same as or different from the withstand voltage of the elements mounted on the circuit substrate 130. For example, the withstand voltage of the elements mounted on the circuit substrate 120 may be higher than the withstand voltage of the elements mounted on the circuit substrate 130. In this case, it is possible to widen the tunable voltage range of the voltage VL in consideration of the characteristics of the photoelectric conversion element 22. The element having a high withstand voltage is, for example, a transistor having a relatively thick gate insulating film, and the element having a low withstand voltage is, for example, a transistor having a relatively thin gate insulating film.

When the power supply voltage of the circuit substrate 130 is a voltage VM between the voltage VH and the voltage VL as illustrated in FIG. 7, the power supply voltage of the waveform shaping circuit 34 is set to the voltage VM, so that the signal amplitude of the node-B may be suppressed and the signal amplitude may be prevented from exceeding the withstand voltage of the processing circuit 36. When the power supply voltage of the selection circuit 38 is set to the voltage VH higher than the power supply voltage of the circuit substrate 130, the signal amplitude in the output line 16 may be increased, and the waveform quality may be improved.

A plurality of types of elements having different withstand voltages may be mixed on the circuit substrate 120. For example, the quenching circuit 32 and the waveform shaping circuit 34 may be configured by elements having a relatively high withstand voltage, and the selection circuit 38 may be configured by elements having a relatively low withstand voltage. In this case, since a finer element generally has a lower withstand voltage, the selection circuit 38 may be realized with a smaller area or a lower output resistance. That is, the degree of freedom of the circuit configuration of the selection circuit 38 may be improved, or the waveform quality of the signal output to the output line 16 may be improved.

An element having a large size, a high withstand voltage and a high current driving capability may be arranged on the circuit substrate 120, and an element having a small size and a high operation speed may be arranged on the circuit substrate 130. Note that the element having a small size and a high operation speed is, for example, a transistor having a relatively short channel length, and the element having a large size, a high withstand voltage and a high current driving capability is, for example, a transistor having a relatively long channel length or a relatively wide channel width. In such a case, the minimum channel length of the transistor constituting the functional block arranged on the circuit substrate 130 is shorter than the minimum channel length of the transistor constituting the functional block arranged on the circuit substrate 120.

In the present embodiment, an interconnection forming the node-C may be an interconnection of one bit or an interconnection group of a plurality of bits. In addition, not all the elements of the processing circuit 36 are necessarily arranged on the circuit substrate 130, and some of the elements may be arranged on the circuit substrate 120. In addition, in the case of a specification in which it is not necessary to maximize the degree of integration of the processing circuit 36, at least a part of the elements constituting the quenching circuit 32, the waveform shaping circuit 34, and the selection circuit 38 may be arranged on the circuit substrate 120. Accordingly, the integration degree of the elements of the signal processing unit 30 other than the processing circuit 36 may be improved.

As described above, according to the present embodiment, in the photoelectric conversion device configured by stacking three or more substrates, it is possible to realize high integration and improved characteristics of each functional block configuring the pixel.

### [Second Embodiment]

A photoelectric conversion device according to a second embodiment of the present invention will be described with reference to FIG. 8. FIG. 8 is a schematic diagram illustrating a configuration example of a pixel in the photoelectric conversion device according to the present embodiment. The same components as those of the photoelectric conversion device according to the first embodiment are denoted by the same reference numerals, and description thereof will be omitted or simplified.

The photoelectric conversion device according to the present embodiment is the same as the photoelectric conversion device according to the first embodiment except that the configuration of the pixel 12 is different. In the present embodiment, differences from the pixel 12 of the first embodiment will be mainly described, and description of portions similar to those of the first embodiment will be appropriately omitted.

As illustrated in FIG. 8, the pixel 12 of the photoelectric conversion device according to the present embodiment is different from the pixel 12 of the photoelectric conversion device according to the first embodiment illustrated in FIG. 6 in that a node-C, which is an output terminal of the processing circuit 36, is connected not only to the selection circuit 38 but also to the quenching circuit 32. By configuring the pixel 12 in this manner, it is possible to feed back the processing result in the processing circuit 36 to the quenching circuit 32 and control the operation of the quenching circuit 32. For example, when the processing circuit 36 has a function of counting the number of photons incident on the pixel 12, that is, a counter for counting the number of pulses generated at the node-B, the quenching circuit 32 can be controlled according to the count value of the counter. For example, when the count value of the counter reaches the maximum count value of the processing circuit 36, the quenching circuit 32 may be controlled to cut off the current path between the node to which the voltage VH is supplied and the photoelectric conversion element 22.

Similarly, the node-C, which is the output terminal of the processing circuit 36, may be connected to the waveform shaping circuit 34, and the processing result in the processing circuit 36 may be fed back to the waveform shaping circuit 34. For example, when the processing circuit 36 has a function of counting the number of photons incident on the pixel 12, that is, a counter for counting the number of pulses generated at the node-B, the waveform shaping circuit 34 may be controlled according to the count value of the counter. For example, when the count value of the counter reaches the maximum count value of the processing circuit 36, the waveform shaping circuit 34 may be controlled so as not to output a pulse to the node-B.

In the present embodiment, an interconnection forming the node-C may be an interconnection of one bit or an interconnection group of a plurality of bits. When the interconnection constituting the node-C is the interconnection group of a plurality of bits, the interconnection to be fed back to the quenching circuit 32 or the waveform shaping circuit 34 may be an interconnection of one bit or interconnections of a plurality of bits.

As described above, according to the present embodiment, in the photoelectric conversion device configured by stacking three or more substrates, it is possible to realize high integration and improved characteristics of each functional block configuring the pixel.

### [Third Embodiment]

A photoelectric conversion device according to a third embodiment of the present invention will be described with reference to FIG. 9 and FIG. 10. FIG. 9 is a schematic diagram illustrating a configuration example of a pixel in the photoelectric conversion device according to the present embodiment. FIG. 10 is a schematic diagram illustrating a configuration example of a pixel in a photoelectric conversion device according to a modification of the present embodiment. The same components as those of the photoelectric conversion device according to the first or second embodiment are denoted by the same reference numerals, and description thereof will be omitted or simplified.

The photoelectric conversion device according to the present embodiment is the same as the photoelectric conversion device according to the first embodiment except that the configuration of the pixel 12 is different. In the present embodiment, differences from the pixel 12 of the first embodiment will be mainly described, and description of portions similar to those of the first embodiment will be appropriately omitted.

In the pixel 12 of the photoelectric conversion device according to the present embodiment, one pixel 12 includes a plurality of photoelectric conversion elements 22. That is, for example, as illustrated in FIG. 9, the pixel 12 includes four photoelectric conversion elements 22A, 22B, 22C and 22D, and four quenching circuits 32A, 32B, 32C and 32D and four waveform shaping circuits 34A, 34B, 34C and 34D corresponding thereto. The pixel 12 having such a configuration is suitable for configuring a SiPM (Silicon Photomultiplier), a macro pixel that realizes one function by a plurality of photoelectric conversion elements, and the like.

The photoelectric conversion elements 22A, 22B, 22C and 22D are connected to the quenching circuits 32A, 32B, 32C and 32D and the waveform shaping circuits 34A, 34B, 34C and 34D via nodes A1, A2, A3, and A4, respectively. Output terminals of the waveform shaping circuits 34A, 34B, 34C and 34D are connected to the processing circuit 36 via nodes B1, B2, B3, and B4. By arranging the plurality of photoelectric conversion elements 22, the quenching circuits 32, and the waveform shaping circuits 34 in this manner, even when the plurality of photoelectric conversion elements 22 are arranged in one pixel 12, the integration degree of the processing circuit 36 may be improved. Although FIG. 9 illustrates a configuration example in which one pixel 12 includes four photoelectric conversion elements 22, the number of photoelectric conversion elements 22 included in one pixel 12 may be two, three, five, or more.

A logic unit 42 may be arranged between the waveform shaping circuits 34A, 34B, 34C and 34D and the processing circuit 36, as illustrated in, e.g., FIG. 10. For example, the output terminals of the waveform shaping circuits 34A, 34B, 34C and 34D may be connected to the input terminals of the logic unit 42, and the output terminal of the logic unit 42 may be connected to the input terminal of the processing circuit 36 via the node-B'. In this case, by arranging the logic unit 42 on the circuit substrate 120 and connecting the circuit substrate 120 and the circuit substrate 130 at the node-B', it is possible to reduce the number of interconnections connecting the circuit substrate 120 and the circuit substrate 130, and it is possible to improve the ease of manufacturing and the yield. The logic unit 42 is a functional block that performs a logic operation on the signals corresponding to incidence of light on the photoelectric conversion elements 22A to 22D, and may be configured by, for example, an OR circuit, a memory, an external light removal circuit that outputs a signal only when the plurality of photoelectric conversion elements 22 detect photons, or the like.

As described above, according to the present embodiment, in the photoelectric conversion device configured by stacking three or more substrates, it is possible to realize high integration and improved characteristics of each functional block configuring the pixel.

### [Fourth Embodiment]

A photoelectric conversion device according to a fourth embodiment of the present invention will be described with reference to FIG. 11 and FIG. 12. FIG. 11 and FIG. 12 are schematic diagrams illustrating a configuration example of the vertical scanning circuit unit in the photoelectric conversion device according to the present embodiment. The same components as those of the photoelectric conversion devices according to the first to third embodiments are denoted by the same reference numerals, and description thereof will be omitted or simplified.

In the present embodiment, a connection relationship between the pixel region 10 and the vertical scanning circuit unit 40 will be described. The configuration described in any of the first to third embodiments may be applicable to each of the plurality of pixels 12 arranged in the pixel region 10. Further, the configuration described in any of the first to third embodiments may be applied to other functional blocks of the photoelectric conversion device.

As illustrated in FIG. 11, the vertical scanning circuit unit 40 in the photoelectric conversion device according to the present embodiment includes a logic unit 44 and a plurality of output units 46 corresponding to each row of the pixel region 10. The logic unit 44 is connected to the control pulse generation unit 90 (see FIG. 1 or FIG. 2). The output unit 46 of each row is connected to the logic unit 44. The logic unit 44 generates a signal for controlling the pixel 12 in response to the control signal generated by the control pulse generation unit 90. The signal generated by the logic unit 44 is supplied to the pixels 12 of the corresponding row via the output unit 46 and the control line 14 of each row.

The logic unit 44 is a functional block that performs logic operation and signal generation and is preferably arranged on the circuit substrate 130 from the viewpoint of improving the degree of integration and realizing high functionality. On the other hand, in order to supply the signal generated by the logic unit 44 to the pixel 12 without deteriorating the waveform quality as much as possible, the output unit 46 is required to have a large driving capability, that is, a large element size. From such a viewpoint, it is desirable that, in the output units 46, the functional blocks corresponding to the signal lines 14A and 14B are arranged on the circuit substrate 120 and the circuit substrate 130, respectively, in accordance with the arrangement of the signal lines 14A and 14B. For example, as illustrated in FIG. 12, when the output unit 46 includes a drive circuit 48A that drives the signal line 14A and a drive circuit 48B that drives the signal line 14B, it is preferable that the drive circuit 48A be arranged on the circuit substrate 120 and the drive circuit 48B be arranged on the circuit substrate 130.

Although an example of the element arrangement in the vertical scanning circuit unit 40 has been described in the present embodiment, the same configuration may be applied to the horizontal scanning circuit unit 60. Accordingly, also in the horizontal scanning circuit unit 60, the same effect as the effect obtained by the vertical scanning circuit unit 40 of the present embodiment may be obtained.

As described above, in the present embodiment, the functional blocks constituting the vertical scanning circuit unit 40 and the horizontal scanning circuit unit 60 are distributed and arranged on the appropriate circuit substrates 120 and 130 according to the arrangement of the functional blocks 30A and 30B of the signal processing unit 30 on the circuit substrates 120 and 130. Therefore, according to the present embodiment, while maintaining the waveform quality of the signals generated by the vertical scanning circuit unit 40 and the horizontal scanning circuit unit 60, it is possible to improve the degree of integration and increase the functionality thereof.

Note that the configuration of the vertical scanning circuit unit 40 described in the present embodiment is merely an example and is not limited thereto. The circuit substrates 120 and 130 to which the functional blocks constituting the vertical scanning circuit unit 40 and the horizontal scanning circuit unit 60 are distributed may be appropriately selected according to characteristics required for each circuit. In general, it is desirable that the functional blocks other than the functional blocks constituting the output stage among the functional blocks constituting the vertical scanning circuit unit 40 and the horizontal scanning circuit unit 60 be constituted by fine elements from the viewpoint of saving the area, saving power, and high integration, and it is preferable to arrange them on the circuit substrate 130. It is preferable that the functional blocks constituting the output stage be arranged on the same substrate as the functional blocks of the corresponding pixels 12.

### [Fifth Embodiment]

A photoelectric conversion device according to a fifth embodiment of the present invention will be described with reference to FIG. 13 and FIG. 14. FIG. 13 and FIG. 14 are schematic diagrams illustrating a configuration example of the readout circuit unit in the photoelectric conversion device according to the present embodiment. The same components as those of the photoelectric conversion devices according to the first to third embodiments are denoted by the same reference numerals, and description thereof will be omitted or simplified.

In the present embodiment, a connection relationship between the pixel region 10 and the readout circuit unit 50 will be described. The configuration described in any of the first to third embodiments is applicable to each of the plurality of pixels 12 arranged in the pixel region 10. Further, the configuration described in any of the first to fourth embodiments can be applied to the other functional blocks of the photoelectric conversion device.

As illustrated in FIG. 13, the readout circuit unit 50 in the photoelectric conversion device according to the present embodiment includes a plurality of receiving circuits 52 corresponding to each column of the pixel region 10. The output line 16 of the corresponding column, a control line 54 to which a control signal from the control pulse generation unit 90 (see FIG. 1 or FIG. 2) is supplied, and an output line 56 to which the signal of the receiving circuit 52 is output are connected to the receiving circuit 52 of each column.

As illustrated in, e.g., FIG. 14, each of the receiving circuits 52 includes a receiving unit 52A that receives the pixel signal output via the output line 16, and a processing unit 52B that processes the pixel signal output from the receiving unit 52A. The output line 16 is connected to an input node of the receiving unit 52A, and an output node of the receiving unit 52A is connected to an input node of the processing unit 52B. The control node of the processing unit 52B is connected to the control line 54, and the output node of the processing unit 52B is connected to the output line 56.

The receiving unit 52A is required to have a high gain and a low offset in order to allow waveform quality degradation of the pixel signal output via the output line 16, and the receiving units 52A of the plurality of receiving circuits 52 is required to have a small characteristic variation. Therefore, it is desirable to increase the element size of the receiving unit 52A. On the other hand, the processing unit 52B is a block that performs predetermined processing on the signal output from the receiving unit 52A, and it is desirable to reduce the element size to increase the degree of integration. From such a viewpoint, as illustrated in, e.g., FIG. 14, it is preferable that the receiving unit 52A be arranged on the circuit substrate 120 and the processing unit 52B be arranged on the circuit substrate 130. By configuring the readout circuit unit 50 in this manner, it is possible to achieve both good characteristics and improved integration. It is preferable to dispose the receiving unit 52A on the circuit substrate 120 from the viewpoint of ease of wiring with the output line 16 disposed on the circuit substrate 120.

In addition, since the DFE 70 is a functional block that performs various logical operations and processes on the pixel signal output from the readout circuit unit 50, it is desirable to increase the degree of integration by disposing the DFE 70 on the circuit substrate 130. Therefore, in view of the ease of wiring between the readout circuit unit 50 and the DFE 70, it is desirable that the processing unit 52B be arranged on the circuit substrate 130.

As described above, in the present embodiment, the functional blocks constituting the readout circuit unit 50 and the DFE 70 are distributed and arranged on the appropriate circuit substrates 120 and 130 according to the arrangement of the functional blocks 30A and 30B of the signal processing unit 30 on the circuit substrates 120 and 130. Therefore, according to the present embodiment, while maintaining the waveform quality of the signal generated by the readout circuit unit 50, the integration degree of the readout circuit unit 50 may be improved and the functionality thereof may be enhanced. Further, the ease of wiring between the readout circuit unit 50 and the DFE 70 may be improved.

Note that the configuration of the readout circuit unit 50 described in the present embodiment is merely an example and is not limited thereto. The circuit substrates 120 and 130 to which the functional blocks constituting the readout circuit unit 50 are distributed may be appropriately selected according to characteristics required for each circuit. In the case where the readout circuit unit 50 includes a sense amplifier, since the sense amplifier is required to have a small offset variation, it is preferable to arrange elements having a relatively large size on the circuit substrate 120. From the viewpoint of saving area, power saving, and high integration, the other elements are desirably formed of fine elements and are preferably arranged on the circuit substrate 130.

### [Sixth Embodiment]

A photoelectric conversion device according to a sixth embodiment of the present invention will be described with reference to FIG. 15. FIG. 15 is a schematic diagram illustrating a configuration example of a transmitter circuit unit in the photoelectric conversion device according to the present embodiment. The same components as those of the photoelectric conversion devices according to the first to third embodiments are denoted by the same reference numerals, and description thereof will be omitted or simplified.

In the present embodiment, a configuration example of the TX 80 will be described. The configuration described in any of the first to fifth embodiments may be applied to other functional blocks of the photoelectric conversion device.

As illustrated in, e.g., FIG. 15, the TX 80 includes a processing unit 82 and an output unit 84. An input node of the processing unit 82 is connected to an output node of the DFE 70. An output node of the processing unit 82 is connected to the output unit 84. The output node of the output unit 84 is also an output node of the photoelectric conversion device 100.

The processing unit 82 is a block that performs predetermined processing such as serialization on the signal output from the DFE 70 and is required to have a small area from the viewpoint of low jitter and low skew. On the other hand, since the output unit 84 outputs a signal to the outside of the photoelectric conversion device 100, it is required to increase the driving capability, that is, increase the element size. From such a viewpoint, as illustrated in, e.g., FIG. 15, it is preferable that the processing unit 82 be arranged on the circuit substrate 120 and the output unit 84 be arranged on the circuit substrate 130. By configuring the TX 80 in this manner, it is possible to achieve both good characteristics and improved integration.

In addition, as described in the fifth embodiment, since it is desirable that the DFE 70 be arranged on the circuit substrate 130, it is desirable that the processing unit 82 be arranged on the circuit substrate 130 in view of the ease of wiring between the DFE 70 and the processing unit 82.

As described above, in the present embodiment, the functional blocks constituting the TX 80 are distributed and arranged on the appropriate circuit substrates 120 and 130 according to the arrangement of the functional blocks 30A and 30B of the signal processing unit 30 on the circuit substrates 120 and 130. Therefore, according to the present embodiment, it is possible to improve the integration degree of the TX 80 while realizing the TX 80 having good characteristics. Further, the ease of wiring between the DFE 70 and the TX 80 may be improved.

Note that the configuration of the TX 80 described in the present embodiment is merely an example, and the present invention is not limited thereto. The circuit substrates 120 and 130 to which the functional blocks constituting the TX 80 are distributed may be appropriately selected according to characteristics required for each circuit. In general, it is desirable that the functional blocks other than the functional blocks constituting the output stage among the functional blocks constituting the TX 80 be constituted by fine elements from the viewpoint of saving the area, saving power, and high integration, and it is preferable to arrange them on the circuit substrate 130. It is preferable that the functional block constituting the output stage is constituted by a low resistance element having a relatively large size and is arranged on the circuit substrate 120.

### [Seventh Embodiment]

A photoelectric conversion device according to a seventh embodiment of the present invention will be described with reference to FIG. 16 to FIG. 18. FIG. 16 to FIG. 18 are schematic cross-sectional views illustrating configuration examples of the photoelectric conversion device according to the present embodiment. The same components as those of the photoelectric conversion devices according to the first to sixth embodiments are denoted by the same reference numerals, and description thereof will be omitted or simplified.

In the present embodiment, examples of a specific cross-sectional structure of the photoelectric conversion device described in the foregoing embodiments will be described.

FIG. 16 to FIG. 18 are schematic cross-sectional views illustrating configuration examples of the photoelectric conversion device in which three substrates of the sensor substrate 110, the circuit substrate 120, and the circuit substrate 130 are stacked. The sensor substrate 110 includes a semiconductor substrate 112 and an interconnection structure layer 114. The circuit substrate 120 includes a semiconductor substrate 122 and an interconnection structure layer 124. The circuit substrate 130 includes a semiconductor substrate 132 and an interconnection structure layer 134.

The sensor substrate 110 and the circuit substrate 120 are joined face-to-face manner so that the front surface side of the semiconductor substrate 112 on which the interconnection structure layer 114 is arranged and the front surface side of the semiconductor substrate 122 on which the interconnection structure layer 114 is arranged face each other. The electrical connection between the sensor substrate 110 and the circuit substrate 120 may be made by a metal bonding 140 between the top interconnection layers constituting each of the interconnection structure layers 114, 124.

The circuit substrate 120 and the circuit substrate 130 are bonded to each other in a face-to-back manner so that the back surface side of the semiconductor substrate 122 and the front surface side of the semiconductor substrate 132 on which the interconnection structure layer 134 is arranged face each other. The bonding between the circuit substrate 120 and the circuit substrate 130 may be configured by a metal bonding 150 similar to the bonding between the sensor substrate 110 and the circuit substrate 120. The electrical connection between the circuit substrate 120 and the circuit substrate 130 may be formed by a connection between an uppermost interconnection layer constituting the interconnection structure layer 134 and through-electrodes penetrating the semiconductor substrate 122 and electrically connected to the interconnection structure layer 124.

On the back surface side of the semiconductor substrate 112, an optical structure layer including microlens ML, a color filter layer (not illustrated), and the like is arranged. That is, the photoelectric conversion devices illustrated in FIG. 16 to FIG. 18 are so-called backside illuminated photoelectric conversion devices. Note that the stacking mode, the bonding method, and the electrical connection of the substrates are not limited to the examples illustrated in FIG. 16 to FIG. 18. For example, the optical structure layer may be disposed on the front surface side of the semiconductor substrate 112 to form a frontside illuminated photoelectric conversion device.

As illustrated in FIG. 16 to FIG. 18, the interconnection structure layer 124 of the circuit substrate 120 may constitute at least a portion of an input interconnection 48I, the signal line 14A, and the output line 16 of the drive circuits 48A and 48B (refer to, e.g., FIG. 12). The interconnection structure layer 124 of the circuit substrate 120 may constitute at least a part of an output interconnection 52AO of the receiving unit 52A, an input interconnection 84I of the output unit 84, and an output interconnection 84O (refer to, e.g., FIG. 14 and FIG. 15). The through-electrodes penetrating the semiconductor substrate 122 may constitute a part of the node-B and the node-C (refer to, e.g., FIG. 12). The interconnection structure layer 134 of the circuit substrate 130 may also include the signal line 14B (refer to, e.g., FIG. 12).

The configuration examples of FIG. 16 to FIG. 18 are different from each other in the arrangement location of pad electrodes for connecting the wiring for electrical connection between the photoelectric conversion device and the external device.

In the configuration example illustrated in FIG. 16, all pad electrodes 116 are formed of an interconnection layer of the same level of the interconnection structure layer 114. With this configuration, when a pad opening 118 reaching the pad electrode 116 is formed in the semiconductor substrate 112 and the interconnection structure layer 114, the depth of the pad opening 118 may be made substantially the same. This facilitates the metallization process.

As described above, the voltage supplied to the sensor substrate 110 is a high voltage, and the circuit substrate 120 is provided with a circuit to which fine processing technology is applied. If the voltage supplied from the pad electrode 116 is supplied only to the sensor substrate 110 as illustrated in FIG. 16, it is possible to avoid the application of the high voltage to the circuit provided on the circuit substrate 120 to which the fine processing technology is applied.

In the configuration example illustrated in FIG. 17, a pad electrode 116 formed of an interconnection layer of the interconnection structure layer 114, a pad electrode 126 formed of an interconnection layer of the interconnection structure layer 124, and a pad electrode 136 formed of an interconnection layer of the interconnection structure layer 134 are provided. Pad openings 118, 128, 138 exposing the pad electrodes 116, 126, 136 have different depths. With this configuration, the wiring length from the pad electrode to which the drive voltage is supplied to the circuit provided on each substrate may be reduced, and the possibility that the operation of the circuit becomes slow due to the propagation delay of the signal may be reduced. Further, it is possible to supply drive voltages corresponding to the elements disposed on the respective substrates from the respective pad electrodes.

In the configuration example illustrated in FIG. 18, a pad electrode 116 formed of an interconnection layer of the interconnection structure layer 114 and a pad electrode 126 formed of an interconnection wiring layer of the interconnection structure layer 124 are provided. By providing the pad electrode 116 for supplying a voltage to the sensor substrate 110 in the interconnection structure layer 114 on the sensor substrate 110 side, a high voltage may be prevented from being applied to a circuit provided in the circuit substrate 120 to which fine processing technology is applied. In addition, since the pad electrode 126 for supplying a voltage to the circuit substrate 120 is provided in the interconnection layer of the interconnection structure layer 124, the wiring length from the pad electrode to the circuit provided on the circuit substrate 120 may be reduced as compared with the case where the pad electrode is provided in the interconnection structure layer 114. Accordingly, it is possible to reduce the possibility that the operation of the circuit becomes slow due to the propagation delay of the signal. The pad electrode for supplying a voltage to the circuit substrate 130 is formed of an interconnection layer at the same level as the pad electrode for supplying a voltage to the circuit substrate 120 from the viewpoint of facilitating the manufacturing process.

Note that the arrangement location of the pad electrode is not limited to the configuration example described in the present embodiment and may be appropriately selected.

### [Eighth Embodiment]

A photodetection system according to an eighth embodiment of the present invention will be described with reference to FIG. 19. FIG. 19 is a block diagram illustrating a schematic configuration of a photodetection system according to the present embodiment. In the present embodiment, a light detection sensor to which the photoelectric conversion device 100 according to any of the first to seventh embodiments is applied will be described.

The photoelectric conversion device 100 described in the first to seventh embodiments may be applied to various optical detection systems. Examples of applicable photodetection systems include imaging systems such as digital still cameras, digital camcorders, surveillance cameras, copying machines, facsimiles, mobile phones, on-vehicle cameras, observation satellites, and the like. A camera module including an optical system such as a lens and an imaging device is also included in the photodetection system. FIG. 19 exemplifies a block diagram of a digital still camera as one of these.

The photodetection system 200 illustrated in FIG. 19 includes an imaging device 201, a lens 202 that forms an optical image of an object on the imaging device 201, an aperture 204 that changes the amount of light passing through the lens 202, and a barrier 206 that protects the lens 202. The lens 202 and the aperture 204 form an optical system that focuses light onto the imaging device 201. The imaging device 201 is the photoelectric conversion device 100 described in any of the first to seventh embodiments, and converts the optical image formed by the lens 202 into image data.

The photodetection system 200 further includes a signal processing unit 208 that processes an output signal output from the imaging device 201. The signal processing unit 208 generates image data from the digital signal output from the imaging device 201. Further, the signal processing unit 208 performs various corrections and compressions as necessary and outputs the generated image data. The imaging device 201 may include an AD conversion unit that generates a digital signal to be processed by the signal processing unit 208. The AD conversion unit may be formed on a semiconductor layer (semiconductor substrate) on which the photon detection element of the imaging device 201 is formed or may be formed on a semiconductor substrate different from the semiconductor layer on which the photon detection element of the imaging device 201 is formed. The signal processing unit 208 may be formed on the same semiconductor substrate as the imaging device 201.

The photodetection system 200 further includes a memory unit 210 for temporarily storing image data and an external interface unit (external I/F unit) 212 for communicating with an external computer or the like. Further, the photodetection system 200 includes a storage medium 214 such as a semiconductor memory for performing storing or reading out of imaging data, and a storage medium control interface unit (storage medium control I/F unit) 216 for performing storing on or reading out from the storage medium 214. The storage medium 214 may be built in the photodetection system 200 or may be detachable. Communication between the storage medium control I/F unit 216 and the storage medium 214 and communication from the external I/F unit 212 may be performed wirelessly.

The photodetection system 200 further includes a general control/operation unit 218 that performs various calculations and controls the entire digital still camera, and a timing generation unit 220 that outputs various timing signals to the imaging device 201 and the signal processing unit 208. Here, the timing signal or the like may be input from the outside, and the photodetection system 200 may include at least the imaging device 201 and the signal processing unit 208 that processes the output signal output from the imaging device 201. The timing generation unit 220 may be mounted on the imaging device 201. Further, the general control/operation unit 218 and the timing generation unit 220 may be configured to perform a part or all of the control functions of the imaging device 201.

The imaging device 201 outputs an imaging signal to the signal processing unit 208. The signal processing unit 208 performs predetermined signal processing on the imaging signal output from the imaging device 201, and outputs the processed image data. The signal processing unit 208 generates an image using the imaging signal. The signal processing unit 208 may be configured to perform distance measurement calculation on the signal output from the imaging device 201.

As described above, according to the present embodiment, by configuring the photodetection system using the photoelectric conversion device according to any of the first to seventh embodiments, it is possible to realize the photodetection system capable of acquiring a higher quality image.

### [Ninth Embodiment]

A range image sensor according to a ninth embodiment of the present invention will be described with reference to FIG. 20. FIG. 20 is a block diagram illustrating a schematic configuration of a range image sensor according to the present embodiment. In the present embodiment, a range image sensor will be described as an example of a photodetection system to which the photoelectric conversion device 100 according to any of the first to seventh embodiments is applied.

As illustrated in FIG. 20, the range image sensor 300 according to the present embodiment may include an optical system 302, a photoelectric conversion device 304, an image processing circuit 306, a monitor 308, and a memory 310. The range image sensor 300 receives light (modulated light or pulsed light) emitted from a light source device 320 toward an object 330 and reflected on the surface of the object 330, and acquires a distance image corresponding to the distance to the object 330.

The optical system 302 includes one or a plurality of lenses and has a function of forming an image of image light (incident light) from the object 330 on a light receiving surface (sensor unit) of the photoelectric conversion device 304.

The photoelectric conversion device 304 is the photoelectric conversion device 100 described in any of the first to seventh embodiments and has a function of generating a distance signal indicating a distance to the object 330 based on image light from the object 330 and supplying the generated distance signal to the image processing circuit 306.

The image processing circuit 306 has a function of performing image processing for constructing a distance image based on the distance signal supplied from the photoelectric conversion device 304.

The monitor 308 has a function of displaying a distance image (image data) obtained by image processing in the image processing circuit 306. The memory 310 has a function of storing (recording) a distance image (image data) obtained by image processing in the image processing circuit 306.

As described above, according to the present embodiment, by configuring the range image sensor using the photoelectric conversion devices according to any of the first to seventh embodiments, it is possible to realize a range image sensor capable of acquiring a range image including more accurate range information in conjunction with improvement in characteristics of the pixels 12.

### [Tenth Embodiment]

An endoscopic surgical system according to a tenth embodiment of the present invention will be described with reference to FIG. 21. FIG. 21 is a schematic diagram illustrating a configuration example of the endoscopic surgical system according to the present embodiment. In the present embodiment, an endoscopic surgical system will be described as an example of a photodetection system to which the photoelectric conversion device 100 according to any of the first to seventh embodiments is applied.

FIG. 21 illustrates a state in which an operator (surgeon) 460 performs surgery on a patient 472 on a patient bed 470 using an endoscopic surgical system 400.

As illustrated in FIG. 21, the endoscopic surgical system 400 according to the present embodiment may include an endoscope 410, a surgical tool 420, and a cart 430 on which various devices for endoscopic surgery are mounted. A CCU (Camera Control Unit) 432, a light source device 434, an input device 436, a processing tool control device 438, a display device 440, and the like may be mounted on the cart 430.

The endoscope 410 includes a lens barrel 412 in which an area of a predetermined length from the tip is inserted into a body cavity of the patient 472, and a camera head 414 connected to the base end of the lens barrel 412. Although FIG. 21 illustrates an endoscope 410 configured as a so-called rigid mirror having a rigid lens barrel 412, the endoscope 410 may be configured as a so-called flexible mirror having a flexible lens barrel. The endoscope 410 is held in a movable state by an arm 416.

The tip of the lens barrel 412 is provided with an opening into which the objective lens is fitted. A light source device 434 is connected to the endoscope 410, and light generated by the light source device 434 is guided to the tip of a lens barrel by a light guide extended inside the lens barrel 412 and is irradiated toward an observation target in the body cavity of the patient 472 through the objective lens. Note that the endoscope 410 may be a direct-viewing mirror, an oblique-viewing mirror, or a side-viewing mirror.

An optical system and a photoelectric conversion device (not illustrated) are provided inside the camera head 414, and reflected light (observation light) from the observation target is focused on the photoelectric conversion device by the optical system. The photoelectric conversion device photoelectrically converts the observation light and generates an electrical signal corresponding to the observation light, that is, an image signal corresponding to the observation image. As the photoelectric conversion device, the photoelectric conversion device 100 described in any of the first to seventh embodiments may be used. The image signal is transmitted to the CCU 432 as RAW data.

The CCU 432 may be configured by a CPU (Central Processing Unit), a GPU (Graphics Processing Unit), or the like, and integrally controls operations of the endoscope 410 and the display device 440. Further, the CCU 432 receives an image signal from the camera head 414 and performs various types of image processing for displaying an image based on the image signal, such as development processing (demosaic processing), on the image signal.

The display device 440 displays an image based on the image signal subjected to the image processing by the CCU 432 under the control of the CCU 432.

The light source device 434 may be configured by, for example, a light source such as an LED (Light Emitting Diode) and supplies irradiation light to the endoscope 410 when photographing a surgical part or the like.

The input device 436 is an input interface to the endoscopic surgical system 400. The user may input various kinds of information and input instructions to the endoscopic surgical system 400 via the input device 436.

The processing tool control device 438 controls the driving of the energy processing tool 450 for tissue ablation, incision, blood vessel sealing, or the like.

The light source device 434 that supplies irradiation light to the endoscope 410 when imaging the surgical part may be configured by, for example, a white light source configured by an LED, a laser light source, or a combination thereof. When the white light source is configured by a combination of the RGB laser light sources, since the output intensity and the output timing of each color (each wavelength) may be controlled with high accuracy, the white balance of the captured image may be adjusted in the light source device 434. In addition, in this case, it is also possible to capture an image corresponding to each of RGB in a time division manner by irradiating the observation target with laser light from each of the RGB laser light sources in a time division manner and controlling driving of the imaging element of the camera head 414 in synchronization with the irradiation timing. According to this method, a color image may be obtained without providing a color filter in the imaging element.

Further, the driving of the light source device 434 may be controlled so as to change the intensity of light to be output every predetermined time. By controlling the driving of the imaging element of the camera head 414 in synchronization with the timing of the change of the intensity of the light to acquire an image in a time-division manner and compositing the image, it is possible to generate an image having a high dynamic range free from so-called blacked up shadows and blown out highlights.

The light source device 434 may be configured to be capable of supplying light in a predetermined wavelength band corresponding to special light observation. In the special light observation, for example, wavelength dependency of absorption of light in body tissue is utilized. Specifically, a predetermined tissue such as a blood vessel in the superficial layer of a mucous membrane is photographed with high contrast by irradiating light in a narrow band as compared with irradiation light (that is, white light) at the time of normal observation. Alternatively, in the special light observation, fluorescence observation in which an image is obtained by fluorescence generated by irradiation with excitation light may be performed. In the fluorescence observation, a body tissue is irradiated with excitation light to observe fluorescence from the body tissue, or a body tissue is locally injected with a reagent such as indocyanine green (ICG), and the body tissue is irradiated with excitation light corresponding to a fluorescence wavelength of the reagent to obtain a fluorescence image. The light source device 434 may be configured to be capable of supplying narrowband light and/or excitation light corresponding to such special light observation.

As described above, according to the present embodiment, by configuring the endoscopic surgical system using the photoelectric conversion devices according to any of the first to seventh embodiments, it is possible to realize an endoscopic surgical system capable of acquiring a better quality image.

### [Eleventh Embodiment]

A photodetection system and a movable object according to an eleventh embodiment of the present invention will be described with reference to FIG. 22A to FIG. 24. FIG. 22A to FIG. 22C are schematic diagrams illustrating a configuration example of a movable object according to the present embodiment. FIG. 23 is a block diagram illustrating a schematic configuration of a photodetection system according to the present embodiment. FIG. 24 is a flowchart illustrating an operation of the photodetection system according to the present embodiment. In the present embodiment, an application example to an on-vehicle camera will be described as a photodetection system to which the photoelectric conversion device 100 according to any of the first to seventh embodiments is applied.

FIG. 22A to FIG. 22C are schematic diagrams illustrating a configuration example of a movable object (vehicle system) according to the present embodiment. FIG. 22A to FIG. 22C illustrate a configuration of a vehicle 500 (automobile) as an example of a vehicle system incorporating a photodetection system to which the photoelectric conversion device 100 according to any of the first to seventh embodiments is applied. FIG. 22A is a schematic front view of the vehicle 500, FIG. 22B is a schematic plan view of the vehicle 500, and FIG. 22C is a schematic rear view of the vehicle 500. The vehicle 500 includes a pair of photoelectric conversion devices 502 on a front thereof. Here, the photoelectric conversion device 502 is the photoelectric conversion device 100 described in any of the first to fifth embodiments. The vehicle 500 includes an integrated circuit 503, an alert device 512, and a main control unit 513.

FIG. 23 is a block diagram illustrating a configuration example of the photodetection system 501 mounted on the vehicle 500. The photodetection system 501 includes photoelectric conversion devices 502, image preprocessing units 515, an integrated circuit 503, and optical systems 514. The photoelectric conversion devices 502 are the photoelectric conversion device 100 described in any of the first to seventh embodiments. The optical system 514 forms an optical image of an object on the photoelectric conversion device 502. The photoelectric conversion device 502 converts the optical image of the object formed by the optical system 514 into an electrical signal. The image preprocessing unit 515 performs predetermined signal processing on the signal output from the photoelectric conversion device 502. The function of the image preprocessing unit 515 may be incorporated in the photoelectric conversion device 502. At least two sets of the optical system 514, the photoelectric conversion device 502, and the image preprocessing unit 515 are provided in the photodetection system 501, and an output from each set of the image preprocessing unit 515 is input to the integrated circuit 503.

The integrated circuit 503 is an integrated circuit for an imaging system application, and includes an image processing unit 504, an optical ranging unit 506, a parallax calculation unit 507, an object recognition unit 508, and an abnormality detection unit 509. The image processing unit 504 processes the image signal output from the image preprocessing unit 515. For example, the image processing unit 504 performs image processing such as development processing and defect correction on the output signal of the image preprocessing unit 515. The image processing unit 504 includes a memory 505 that temporarily holds the image signal. In the memory 505, for example, the position of a known defective pixel in the photoelectric conversion device 502 may be stored.

The optical ranging unit 506 performs focusing and distance measurement of the object. The parallax calculation unit 507 calculates distance measurement information (distance information) from a plurality of image data (parallax images) acquired by the plurality of photoelectric conversion devices 502. Each of the photoelectric conversion devices 502 may have a configuration capable of acquiring various kinds of information such as distance information. The object recognition unit 508 recognizes an object such as a vehicle, a road, a sign, or a person. Upon detecting an abnormality in the photoelectric conversion device 502, the abnormality detection unit 509 notifies the main control unit 513 of the abnormality.

The integrated circuit 503 may be realized by dedicatedly designed hardware, may be realized by a software module, or may be realized by a combination thereof. Further, it may be realized by FPGA (Field Programmable Gate Array), ASIC (Application Specific Integrated Circuit), or the like, or may be realized by a combination of these.

The main control unit 513 integrally controls the operations of the photodetection system 501, the vehicle sensor 510, the control unit 520, and the like. The vehicle 500 may not include the main control unit 513. In this case, the photoelectric conversion device 502, the vehicle sensor 510, and the control unit 520 transmit and receive control signals via a communication network. For example, the CAN standard may be applied to the transmission and reception of the control signal.

The integrated circuit 503 has a function of receiving a control signal from the main control unit 513 or transmitting a control signal or a setting value to the photoelectric conversion device 502 by its own control unit.

The photodetection system 501 is connected to the vehicle sensor 510 and may detect a traveling state of the host vehicle such as a vehicle speed, a yaw rate, and a steering angle, an environment outside the host vehicle, and states of other vehicles and obstacles. The vehicle sensor 510 is also a distance information acquisition unit that acquires distance information to the object. In addition, the photodetection system 501 is connected to a driving support control unit 511 that performs various kinds of driving support such as automatic steering, automatic traveling, and a collision prevention function. In particular, with respect to the collision determination function, the driving support control unit 511 estimates the collision with other vehicles or obstacles based on the detection results of the photodetection system 501 and the vehicle sensor 510. Thus, avoidance control when a collision is estimated and activation of the safety device at the time of the collision are performed.

The photodetection system 501 is also connected to an alert device 512 that issues an alert to the driver based on the determination result of the collision determination unit. For example, when the determination result of the collision determination unit is that the possibility of a collision is high, the main control unit 513 performs vehicle control for avoiding a collision and reducing damage by applying a brake, returning an accelerator, suppressing engine output, or the like. The alert device 512 alerts the user by sounding an alarm such as a sound, displaying alert information on a display screen of a car navigation system, a meter panel, or the like, or vibrating a seat belt or a steering wheel.

In the present embodiment, an image of the surroundings of the vehicle, for example, the front or the rear, is captured by the photodetection system 501. FIG. 22B illustrates an arrangement example of the photodetection system 501 in a case where the photodetection system 501 captures an image in front of the vehicle.

As described above, the photoelectric conversion devices 502 are disposed in front of the vehicle 500. Specifically, it is preferable that a center line with respect to an advancing/retreating direction or an outer shape (for example, a vehicle width) of the vehicle 500 is regarded as a symmetry axis, and two photoelectric conversion devices 502 are disposed line-symmetrically with respect to the symmetry axis in order to acquire distance information between the vehicle 500 and an object to be imaged and determine a possibility of collision. In addition, the photoelectric conversion devices 502 are preferably disposed so as not to interfere with the driver's visual field when the driver visually recognizes a situation outside the vehicle 500 from the driver's seat. The alert device 512 is preferably disposed so as to easily enter the field of view of the driver.

Next, a failure detection operation of the photoelectric conversion device 502 in the photodetection system 501 will be described with reference to FIG. 24. The failure detection operation of the photoelectric conversion device 502 may be performed in accordance with steps S110 to S180 illustrated in FIG. 24.

Step S110 is a step of performing setting at the time of start-up of the photoelectric conversion device 502. That is, the setting for the operation of the photoelectric conversion device 502 is transmitted from the outside of the photodetection system 501 (for example, the main control unit 513) or the inside of the photodetection system 501, and the imaging operation and the failure detection operation of the photoelectric conversion device 502 are started.

Next, in step S120, pixel signals are acquired from the effective pixels. In step S130, an output value from a failure detection pixel provided for failure detection is acquired. The failure detection pixel may include a photoelectric conversion element in the same manner as the effective pixel. A predetermined voltage is written to the photoelectric conversion element of the failure detection pixel. The failure detection pixel outputs a signal corresponding to the voltage written in the photoelectric conversion element. Note that step S120 and step S130 may be reversed.

Next, in step S140, a classification of the output expected value of the failure detection pixel and the actual output value from the failure detection pixel is performed. As a result of the classification in step S140, when the output expected value matches the actual output value, the process proceeds to step S150, it is determined that the imaging operation is normally performed, and the process step proceeds to step S160. In step S160, the pixel signals of the scanning row are transmitted to the memory 505 and temporarily stored. After that, the process returns to step S120 to continue the failure detection operation. On the other hand, as a result of the classification in step S140, when the output expected value does not coincide with the actual output value, the process proceeds to step S170. In step S170, it is determined that there is an abnormality in the imaging operation, and an alert is notified to the main control unit 513 or the alert device 512. The alert device 512 causes the display unit to display that an abnormality has been detected. Thereafter, in step S180, the photoelectric conversion device 502 is stopped, and the operation of the photodetection system 501 is ended.

In the present embodiment, an example in which the flowchart is looped for each row is described, but the flowchart may be looped for each plurality of rows, or the failure detection operation may be performed for each frame. The alert of step S170 may be notified to the outside of the vehicle via a wireless network.

In addition, in the present embodiment, the control in which the own vehicle does not collide with another vehicle has been described, but the present invention is also applicable to control in which the own vehicle follows another vehicle and performs automatic driving, control in which the vehicle performs automatic driving so as not to protrude from a lane, and the like. Further, the photodetection system 501 is not limited to a vehicle such as an own vehicle, and may be applied to, for example, other movable objects (mobile devices) of a ship, an aircraft, an industrial robot, or the like. In addition, the present invention is not limited to the movable object and may be widely applied to equipment using object recognition, such as an advanced road traffic system (ITS: Intelligent Transport Systems).

### [Twelfth Embodiment]

A photodetection system according to a twelfth embodiment of the present invention will be described with reference to FIG. 25A and FIG. 25B. FIG. 25A and FIG. 25B are schematic diagrams illustrating a configuration example of the photodetection system according to the present embodiment. In the present embodiment, an application example to eyeglasses (smartglasses) will be described as a photodetection system to which the photoelectric conversion device 100 according to any of the first to seventh embodiments is applied.

FIG. 25A illustrates eyeglasses 600 (smartglasses) according to one application example. The eyeglasses 600 include lenses 601, a photoelectric conversion device 602, and a control device 603.

The photoelectric conversion device 602 is the photoelectric conversion device 100 described in any of the first to seventh embodiments and is provided on the lens 601. One photoelectric conversion device 602 may be provided, or a plurality of photoelectric conversion devices may be provided. When a plurality of photoelectric conversion devices 602 are used, a combination of a plurality of types of photoelectric conversion devices 602 may be used. The arrangement position of the photoelectric conversion device 602 is not limited to that in FIG. 25A. A display device (not illustrated) including a light emitting device such as an OLED or an LED may be provided on the back surface side of the lens 601.

The control device 603 functions as a power supply that supplies power to the photoelectric conversion device 602 and the display device. The control device 603 has a function of controlling the operations of the photoelectric conversion device 602 and the display device. The lens 601 may be provided with an optical system for focusing light on the photoelectric conversion device 602.

FIG. 25B illustrates eyeglasses 610 (smartglasses) according to another application example. The eyeglasses 610 include lenses 611 and a control device 612. A photoelectric conversion device (not illustrated) corresponding to the photoelectric conversion device 602 and the display device may be mounted on the control device 612.

The lens 611 is provided with a photoelectric conversion device in the control device 612 and an optical system for projecting light from the display device, and an image is projected thereon. The control device 612 functions as a power supply that supplies power to the photoelectric conversion device and the display device and has a function of controlling operations of the photoelectric conversion device and the display device.

The control device 612 may further include a line-of-sight detection unit that detects the line of sight of the wearer. In this case, an infrared light emitting unit may be provided in the control device 612, and infrared light emitted from the infrared light emitting unit may be used for detection of a line of sight. Specifically, the infrared light emitting unit emits infrared light to the eyeball of the user who is watching the display image. A captured image of the eyeball is obtained by detecting reflected light of the emitted infrared light from the eyeball by an imaging unit having a light receiving element. By providing a reduction unit that reduces light from the infrared light emitting unit to the display unit in a plan view, it is possible to reduce degradation of image quality.

The line of sight of the user with respect to the display image may be detected from the captured image of the eyeball obtained by capturing the infrared light. Any known technique may be applied to the line-of-sight detection using the captured image of the eyeball. As an example, a line-of-sight detection method based on a Purkinje image due to reflection of irradiation light on the cornea may be used. More specifically, the line-of-sight detection process based on the pupil corneal reflection method is performed. The line of sight of the user may be detected by calculating a line-of-sight vector representing the orientation (rotation angle) of the eyeball based on the image of the pupil included in the captured image of the eyeball and the Purkinje image using the pupil corneal reflex method.

The display device according to the present embodiment may include a photoelectric conversion device having a light receiving element and may be configured to control a display image based on line-of-sight information of a user from the photoelectric conversion device. Specifically, the display device determines, based on the line-of-sight information, a first viewing area that the user gazes at and a second viewing area other than the first viewing area. The first viewing area and the second viewing area may be determined by a control device of the display device or may be determined by an external control device. When the determination is made by the external control device, the determination result is transmitted to the display device via communication. In the display area of the display device, the display resolution of the first viewing area may be controlled to be higher than the display resolution of the second viewing area. That is, the resolution of the second viewing area may be lower than the resolution of the first viewing area.

The display area may include a first display area and a second display area different from the first display area, and an area having a high priority may be determined from the first display area and the second display area based on the line-of-sight information. The first display area and the second display area may be determined by a control device of the display device or may be determined by an external control device. When the determination is made by the external control device, the determination result is transmitted to the display device via communication. The resolution of the high priority area may be controlled to be higher than the resolution of the area other than the high priority area. That is, the resolution of the area having a relatively low priority may be lowered.

Note that the AI may be used to determine the first viewing area or the area with a high priority. The AI may be a model configured to estimate an angle of the line of sight and a distance to a target object ahead of the line of sight from the image of the eyeball using the image of the eyeball and the direction in which the eyeball of the image is actually viewed as teacher data. The AI program may be included in the display device, the photoelectric conversion device, or the external device. When the external device has the program, the information may be transmitted to the display device via communication.

In the case of performing display control based on visual recognition detection, the present invention may be preferably applied to smartglasses further including a photoelectric conversion device that captures an image of the outside. Smartglasses may display captured external information in real time.

### [Modified Embodiments]

The present invention is not limited to the above-described embodiments, and various modifications are possible.

For example, an example in which a part of the configuration of any of the embodiments is added to another embodiment or an example in which a part of the configurations of any of the embodiments is substituted with some of the configurations of another embodiment is also an embodiment of the present invention.

Further, the circuit configuration of the pixel 12 is not limited to the above-described embodiments. For example, a switch such as a transistor may be provided between the photoelectric conversion element 22 and the quenching circuit 32 or between the photoelectric conversion element 22 and the signal processing unit 30 to control the electrical connection state therebetween. Further, a switch such as a transistor may be provided between the node to which the voltage VH is supplied and the quenching circuit 32 and/or between the node to which the voltage VL is supplied and the photoelectric conversion element 22 to control an electrical connection state therebetween. A plurality of photoelectric conversion elements 22 may be provided for one pixel 12.

Further, in the above embodiment, a configuration in which a counter circuit is used as the processing circuit 36 has been described, but a TDC (Time to Digital Converter) and a memory may be used instead of the counter circuit. In this case, the generation timing of the pulse signal output from the waveform shaping circuit 34 is converted into a digital signal by the TDC. A control pulse pREF (reference signal) is supplied to the TDC from the vertical scanning circuit unit 40 via the control line 14 when the timing of the pulse signal is measured. The TDC acquires, as a digital signal, a signal when an input timing of a signal output from each pixel 12 is set to a relative time with reference to the control pulse pREF.

Although the photoelectric conversion device in which the sensor substrate 110, the circuit substrate 120, and the circuit substrate 130 are stacked in this order has been described in the above embodiment, the stacking order of the circuit substrate 120 and the circuit substrate 130 may be reversed.

The present invention may also be realized by a processing of supplying a program for realizing one or more functions of the above-described embodiments to a system or an apparatus via a network or a storage medium, and reading out and executing the program by one or more processors in a computer of the system or the apparatus. In addition, the present invention may also be realized by a circuit that realizes one or more functions (for example, ASIC).

It should be noted that the above-described embodiments are merely specific examples for carrying out the present invention, and the technical scope of the present invention should not be interpreted in a limited manner by these embodiments. That is, the present invention can be implemented in various forms without departing from the technical idea or the main features thereof.

The present invention is not limited to the above-described embodiments, and various changes and modifications can be made without departing from the spirit and scope of the present invention. Accordingly, the following claims are to be accorded the full scope of the invention.

The present application claims priority based on Japanese Patent Application No. 2023-008010 filed January 23, 2023, and Japanese Patent Application No. 2024-000212 filed January 4, 2024, the entire contents of which are incorporated herein by reference.

### [Reference Signs List]

12 ... pixel
20 ... photoelectric conversion unit
22 ... photoelectric conversion element
30 ... signal processing unit
30A and 30B ... functional block
40 ... vertical scanning circuit unit
50 ... readout circuit unit
60 ... horizontal scanning circuit unit
70 ... DFE
80 ... TX
90 ... control pulse generation unit
100 ... photoelectric conversion device
110 ... sensor substrate
120 and 130 ... circuit substrate

## Claims

1. A photoelectric conversion device, configured by stacking at least a first substrate, a second substrate, and a third substrate, comprising:
a plurality of pixels each including: a photoelectric conversion unit including an avalanche photodiode; and a signal processing unit configured to process a signal output from the photoelectric conversion unit,
wherein the signal processing unit of each of the plurality of pixels includes: a quenching circuit connected to the avalanche photodiode; and a processing circuit configured to process a signal according to incidence of light on the avalanche photodiode,
wherein the avalanche photodiode is arranged on the first substrate,
wherein at least a part of the quenching circuit is arranged on the second substrate,
wherein at least a part of the processing circuit is arranged on the third substrate,
wherein each of the plurality of pixels includes a plurality of electrical connection portions between the second substrate and the third substrate, and
wherein a part of the plurality of electrical connection portions constitutes a part of an input signal line to the processing circuit, and another part of the plurality of electrical connection portions constitutes a part of an output signal line from the processing circuit.

2. The photoelectric conversion device according to claim 1,
wherein the signal processing unit of each of the plurality of pixels further includes:
a waveform shaping circuit connected to a connection node between the avalanche photodiode and the quenching circuit and configured to convert an analog signal output from the photoelectric conversion unit into a pulse signal; and
a selection circuit configured to select an output of a signal processed by the processing circuit.

3. The photoelectric conversion device according to claim 2, wherein at least a part of the waveform shaping circuit and at least a part of the selection circuit are arranged on the second substrate.

4. The photoelectric conversion device according to claim 3, wherein the waveform shaping circuit is connected to the processing circuit via the part of the plurality of electrical connection portions.

5. The photoelectric conversion device according to claim 3 or 4, wherein the processing circuit is connected to the selection circuit via the another part of the plurality of electrical connection portions.

6. The photoelectric conversion device according to any one of claims 3 to 5, wherein the processing circuit is connected to the quenching circuit via the another part of the plurality of electrical connection portions.

7. The photoelectric conversion device according to any one of claims 2 to 6, further comprising: a scanning circuit unit configured to supply a control signal to the plurality of pixels in units of rows or units of columns,
wherein the scanning circuit unit includes:
a logic unit configured to generate a signal for controlling the plurality of pixels; and
a plurality of output units arranged corresponding to each of the plurality of rows or the plurality of columns and each configured to supply to the signal generated by the logic unit to the pixels of a corresponding row or a corresponding column, and
wherein each of the plurality of output units includes:
a first drive circuit arranged on the second substrate and configured to generate a signal for driving the selection circuit; and
a second drive circuit arranged on the third substrate and configured to generate a signal for driving the processing circuit.

8. The photoelectric conversion device according to any one of claims 1 to 7, further comprising: a readout circuit unit configured to process signals output from the plurality of pixels,
wherein the readout circuit unit includes a plurality of receiving circuits arranged corresponding to each of the plurality of rows or the plurality of columns, and
wherein each of the plurality of receiving circuits includes:
a receiving unit arranged on the second substrate and configured to receive a signal output from pixels of a corresponding row or a corresponding column; and
a processing unit arranged on the third substrate and configured to process a signal output from the receiving unit.

9. The photoelectric conversion device according to claim 8, further comprising a signal processing circuit unit arranged on a third substrate and configured to perform digital signal processing on a signal output from the readout circuit unit.

10. The photoelectric conversion device according to any one of claims 1 to 9, further comprising: a transmitter circuit unit configured to output a signal based on signals generated by the plurality of pixels to an outside,
wherein the transmitter circuit unit includes:
a processing unit arranged on the third substrate and configured to process a predetermined processing on a signal based on signals generated by the plurality of pixels; and
an output unit arranged on the second substrate and configured to output a signal processed by the processing unit to an outside.

11. The photoelectric conversion device according to any one of claims 1 to 10, wherein the photoelectric conversion unit of each of the plurality of pixels includes a plurality of avalanche photodiodes.

12. The photoelectric conversion device according to claim 11,
wherein the signal processing unit of each of the plurality of pixels further includes a logic unit arranged on the second substrate and configured to perform a logical operation on a signal according to incidence of light on the plurality of avalanche photodiodes, and
wherein the logic unit is connected to the processing circuit via the part of the plurality of electrical connection portions.

13. The photoelectric conversion device according to any one of claims 1 to 12, wherein a thickness of a gate insulating film of a transistor constituting a functional block arranged on the second substrate is thicker than a thickness of a gate insulating film of a transistor constituting a functional block arranged on the third substrate.

14. The photoelectric conversion device according to any one of claims 1 to 13, wherein a minimum channel length of a transistor constituting a functional block arranged on the third substrate is shorter than a minimum channel length of a transistor constituting a functional block arranged on the second substrate.

15. The photoelectric conversion device according to any one of claims 1 to 13, wherein the first substrate, the second substrate, and the third substrate are stacked in this order.

16. A photoelectric conversion device, configured by stacking at least a first substrate, a second substrate, and a third substrate, comprising:
a plurality of pixels arranged to form a plurality of rows and a plurality of columns and each including: a photoelectric conversion unit including an avalanche photodiode; and a signal processing unit configured to process a signal output from the photoelectric conversion unit; and
a plurality of output lines provided corresponding to the plurality of rows or the plurality of columns and each connected to pixels of a corresponding row or a corresponding column,
wherein the signal processing unit of each of the plurality of pixels includes: an input node connected to the avalanche photodiode; a processing circuit configured to process a signal according to incidence of light on the avalanche photodiode; and an output node connected to the output line,
wherein the avalanche photodiode is arranged on the first substrate,
wherein the input node and the output node of the signal processing unit, and the output line are arranged on the second substrate, and
wherein at least a part of the processing circuit is arranged on the third substrate.

17. The photoelectric conversion device according to claim 16,
wherein the signal processing unit of each of the plurality of pixels further includes:
a quenching circuit connected to the avalanche photodiode;
a waveform shaping circuit connected to a connection node between the avalanche photodiode and the quenching circuit and configured to convert an analog signal output from the photoelectric conversion unit to a pulse signal; and
a selection circuit configured to select an output of a signal processed by the processing circuit to the output line, and
wherein at least a part of the quenching circuit, at least a part of the waveform shaping circuit, and at least a part of the selection circuit are arranged on the second substrate.

18. The photoelectric conversion device according to any one of claims 1 to 17, further comprising a first pad electrode to which a power supply voltage to the first substrate is supplied,
wherein the first pad electrode is arranged on the first substrate.

19. The photoelectric conversion device according to claim 18, further comprising a second pad electrode to which a power supply voltage to the second substrate is supplied,
wherein the second pad electrode is arranged on the first substrate.

20. The photoelectric conversion device according to claim 18, further comprising a second pad electrode to which a power supply voltage to the second substrate is supplied,
wherein the second pad electrode is arranged on the second substrate.

21. The photoelectric conversion device according to any one of claims 18 to 20, further comprising a third pad electrode to which a power supply voltage to the third substrate is supplied,
wherein the third pad electrode is arranged on the first substrate.

22. The photoelectric conversion device according to any one of claims 18 to 20, further comprising a third pad electrode to which a power supply voltage to the third substrate is supplied,
wherein the third pad electrode is arranged on the second substrate.

23. The photoelectric conversion device according to any one of claims 18 to 20, further comprising a third pad electrode to which a power supply voltage to the third substrate is supplied,
wherein the third pad electrode is arranged on the third substrate.

24. A photodetection system comprising:
the photoelectric conversion device according to any one of claims 1 to 23; and
a signal processing device configured to process a signal output from the photoelectric conversion device.

25. The photodetection system according to claim 24, wherein the signal processing device is configured to generate a distance image representing distance information to an object based on the signal.

26. A movable object comprising:
the photoelectric conversion device according to any one of claims 1 to 23;
a distance information acquisition means configured to acquire distance information to an object from a parallax image based on a signal output from the photoelectric conversion device; and
a control means configured to control the movable object based on the distance information.
